# EUROPEAN PATENT APPLICATION

(11) **EP 4 611 045 A1**
(43) Date of publication of application: **03.09.2025**
(21) Application number: 23888100.7
(22) Date of filing: 10.11.2023
(51) Int. Cl.: H01L 31/0216, H01L 31/0224, H01L 31/20

(54) **BATTERY CELL PREPARATION METHOD AND BATTERY CELL**

(30) Priority: 11.11.2022 CN 202211415351
(71) Applicant: Suzhou Sunwell New Energy Co., Ltd., Suzhou, Jiangsu 215127 (CN)
(72) Inventor: YAO, Yu, Suzhou, Jiangsu 215127 (CN); LI, Zhongtian, Suzhou, Jiangsu 215127 (CN); SHEN, Yiming, Suzhou, Jiangsu 215127 (CN); LU, Chengjie, Suzhou, Jiangsu 215127 (CN); HUANG, Xiaoru, Suzhou, Jiangsu 215127 (CN)
(74) Representative: Murgitroyd & Company
(86) International application number: PCT/CN2023/130885
(87) International publication number: WO 2024/099415

(57) **Abstract**

Disclosed in the present invention is a battery cell preparation method. A second mask layer is formed on the edge of a battery cell substrate, wherein the edge of the battery cell substrate at least comprises all side walls of the battery cell substrate, such that the situation where all the side walls of the battery cell substrate are in an exposed state is avoided; and during the process of preparing a metal gate line by means of electroplating, damage to the side walls of the battery cell substrate is avoided, so that the efficiency and yield of prepared battery cells can be improved. **In** particular, during the process of preparing a battery cell having a double-sided electrode, a second mask layer forms an insulating area on side walls of a battery cell substrate, such that a short circuit caused by local interconnection of the double-sided electrode can be prevented.

## Description

### TECHNICAL FIELD

The invention relates to fields of photovoltaic cells and semiconductor manufacturing, and particularly relates to a solar cell and a preparing method therefor.

### BACKGROUND

As the structure of crystalline silicon solar cells were developed to high open voltage, low-temperature processes in every aspects are applied more and more. Taking silicon-based heterojunction cells as an example, materials deposited on a solar cell substrate in sequence at low temperature are intrinsic amorphous silicon layer, doped amorphous silicon layer and transparent conductive oxide layer (TCO layer). The deposition method of amorphous silicon layer is usually plasma enhanced chemical vapor deposition (PECVD), and the deposition method of TCO layer is physical vapor deposition such as magnetron sputtering or reactive plasma deposition. In the deposition of a material from gas phase to solid phase, sidewalls of the solar cell substrate in a thickness direction will inevitably be deposited by the material. Since a light-receiving surface and a back surface of the bifacial solar cell are two polarities of the solar cell, it is crucial to form an insulating area on the sidewalls or an edge of the surfaces to prevent short circuit caused by local interconnection of the two polarities.

On the other hand, in a process of preparing metal grid lines by electroplating, when a solution containing metal ions contacts the sidewalls of the solar cell substrate, metal will also be deposited on the sidewalls in the electroplating process, so it is usually needed to remove the deposited metal from the sidewalls of the solar cell substrate by etching-back, thereby reducing occurrence of sidewall short circuit. However, the etching-back often damages the sidewalls of the solar cell substrate, thereby affecting the efficiency and yield of the prepared solar cell. In the electroplating process, if the sidewalls of the solar cell substrate are not protected at all, the metal deposited on the sidewalls of the solar cell substrate is almost as thick as the metal deposited on the surfaces of the solar cell substrate, and the metal deposited on the sidewalls of the solar cell substrate is removed by etching-back, the metal deposited on the surfaces of the solar cell substrate will also be etched, so the etching-back method cannot be used unless the metal deposited on the surfaces of the solar cell substrate is protected in the etching-back process.

In another aspect, if the thickness of the TCO layer is increased, the conductivity is enhanced, but the light transmittance is reduced. If the thickness of the TCO layer 13 is reduced, the conductivity is weakened, but the light transmittance is improved. Existing technology cannot solve this technical contradiction.

In addition, an anti-reflection layer or the TCO layer on the solar cell substrate is usually formed by physical vapor deposition or chemical vapor deposition. For the heterojunction cell, the transparent conductive oxide is deposited on the light-receiving surface and the back surface to form TCO layers. The solar cell substrate is usually placed on a tray with openings, and the tray passes through a target position section for depositing a light-receiving surface layer and a target position section for depositing a back surface layer. The position of the solar cell substrate in contact with the tray is shielded, such that the transparent conductive oxide cannot be deposited to form a TCO layer, thereby exposing the doped semiconductor layer (for example, the amorphous silicon or microcrystalline silicon layer) on the solar cell substrate . The surface of the doped semiconductor layer 12 is directly in contact with metal particles in external environment, which reduces the efficiency of the prepared solar cell. For example, in an electroplating copper process, the surface of the doped semiconductor layer is directly in contact with the seed layer, which has two risks: (1) the heating treatment (for example, drying) process causes the seed layer to diffuse into the solar cell substrate through the doped semiconductor layer, resulting in a loss of the electrical performance of the solar cell; and (2) a solution for removing the seed layer contains copper ions, which are easy to adhere to the doped semiconductor layer during cleaning and diffuse into the solar cell during subsequent heating treatment and outdoor use of the solar cell, also resulting in a loss of the electrical performance of the solar cell.

### SUMMARY

An object of the invention is to provide a preparing method for a solar cell, which at least solves one of the problems mentioned in the background.

Embodiments of the invention provide a method for preparing a solar cell, including the following steps:
S11, forming a first mask layer on a first face and/or a second face of a solar cell substrate;
S12, forming mask openings on the first mask layer;
S13, forming a second mask layer on an edge of the solar cell substrate, the edge of the solar cell substrate at least comprising all sidewalls of the solar cell substrate;
S14, electroplating to form metal grid lines in the mask openings; and
S15, removing the first mask layer and the second mask layer.

In some embodiments, the first mask layer is made of a photosensitive resin, and the second mask layer is made of a thermosetting resin.

In some embodiments, surfaces of the solar cell substrate are divided into three areas A, B and C; the first face of the solar cell substrate is composed of the A area and the B area, wherein the B area is adjacent to an edge of the first face; on the first face, the B area is annular and surrounds the A area; and the C area is all sidewalls of the solar cell substrate;
the first mask layer covers all the A area on the first face and at least part of the B area on the first face; the second mask layer covers all the C area and at least part of the B area on the first face; and a part of the first mask layer and a part of the second mask layer overlap in the B area on the first face.

In some embodiments, the second face of the solar cell substrate is composed of the A area and the B area, wherein the B area is adjacent to an edge of the second face; on the second face, the B area is annular and surrounds the A area; the first mask layer covers all the A area on the second face and at least part of the B area on the second face; the second mask layer covers at least part of the B area on the second face; and a part of the first mask layer and a part of the second mask layer overlap in the B area on the second face.

In some embodiments, the second mask layer is in a shape of "C" in a cross section along an up-down direction.

In some embodiments, the overlapping parts of the first mask layer and the second mask layer in the B area are annular.

In some embodiments, the edge of the first mask layer comprises a first inclined thinning layer, the edge of the second mask layer comprises a second inclined thinning layer, and the first inclined thinning layer and the second inclined thinning layer overlap to form the overlapping parts of the first mask layer and the second mask layer in the B area.

In some embodiments, coated second mask material covers the edge of the first face to form a first edge strip, a second edge strip, a third edge strip and a fourth edge strip in sequence, and widths of the first edge strip, the second edge strip, the third edge strip and the fourth edge strip are d3, d4, d5 and d6 in sequence, wherein d3, d4, d5 and d6 are in a range of 0.2 - 5 mm.

In some embodiments, left and right edges of the first face of the solar cell substrate are coated to form a first edge strip and a third edge strip firstly, and then upper and lower edges of the first face of the solar cell substrate are coated to form a second edge strip and a fourth edge strip; the first edge strip intersects with the second edge strip, the first edge strip intersects with the fourth edge strip, the third edge strip intersects with the second edge strip, and the third edge strip intersects with the fourth edge strip.

In some embodiments, second mask material is coated on an edge of the first face of the solar cell substrate in a counterclockwise or clockwise direction to form an annular area from end-to-end.

In some embodiments, the second mask layer is dissolved and removed, and then the first mask layer is swelled and separated from the solar cell substrate.

In some embodiments, when the metal grid lines are an easily-oxidized metal, an anti-oxidation layer is arranged on surface of the metal grid lines.

In some embodiments, the anti-oxidation layer covers a top and a sidewall of the metal grid lines.

In some embodiments, the anti-oxidation layer is obtained through a chemical displacement reaction.

In some embodiments, the step S13 is performed after the step S11 and before the step S14; or the step S13 is performed before the step S11.

In some embodiments, a first mask layer is formed on the first face and the second face of the solar cell substrate firstly, the first mask layer does not completely cover the first face of the solar cell substrate and exposes four edges of the first face of the solar cell substrate, the first mask layer does not completely cover the second face of the solar cell substrate and exposes four edges of the second face of the solar cell substrate; and a second mask layer is then formed on the four edges of the first face and the second face of the solar cell substrate exposed, the second mask layer is formed on the first mask layer and does not cover a mask pattern.

In some embodiments, on a same side of the solar cell substrate, a distance from one boundary of the first mask layer to a first boundary of the solar cell substrate is h1, a distance from one side of the mask pattern to the first boundary of the solar cell substrate is h2, and a distance from one side of the second mask layer to the first boundary of the solar cell substrate is h3; and h1 is greater than 0 and h1 < h3 < h2.

In some embodiments, the solar cell substrate includes a continuous first side, a second side, and a third side, the first side and the third side are located on two sides of the second side, and a length of the second side of the solar cell substrate is k1; the first mask layer is symmetrically distributed along a perpendicular bisector of the second side of the solar cell substrate, and a length of the first mask layer along an extension direction of the second side of the solar cell substrate is k2; a length of the mask pattern along the extension direction of the second side of the solar cell substrate is k3, and the mask pattern is symmetrically distributed on the first mask layer along the perpendicular bisector of the second side of the solar cell substrate; a distance from one boundary of the mask pattern on one side of the first side to the first side is h31, and a distance from the other boundary of the mask pattern on one side of the third side to the third side is h32, h31 and h32 are within a range of h3; and k1 > k2, 2h3 + k2 > k1 and 2h3 + k3 < k1 are satisfied.

In some embodiments, a tolerance of k1 is ±p; and k1 - k2 - p > 0 and (k1 + p - k2) / 2 < h3 < (k1 - p - k3) / 2 are satisfied.

In some embodiments, the metal grid lines are grid lines with width gradients.

In some embodiments, a width of the second mask material covered on an upper surface of the solar cell substrate is greater than a width of the second mask material covered on a lower surface of the solar cell substrate.

In some embodiments, when the first mask layer is formed on the first face and the second face of the solar cell substrate, the first face of the solar cell substrate is a light-receiving surface, and the second face of the solar cell substrate is a back light surface, so that the thickness of the first mask layer on the light-receiving surface is greater than the thickness of the first mask layer on the back light surface.

In some embodiments, the number of the metal grid lines on the light-receiving surface is less than the number of the metal grid lines on the back light surface.

In some embodiments, the method further comprises the following steps:
S31, preparing a TCO layer on a substrate structure layer, and a thickness of at least one TCO layer being M to form a TCO thinning layer;
S32, electroplating metal grid lines on the TCO thinning layer, controlling widths of the metal grid lines on the one TCO thinning layer to be N according to the thickness of the one TCO thinning layer,, and a distance between adjacent metal grid lines on the one TCO thinning layer to be T;
wherein, M is in a range of 40 nm to 80 nm, N is in a range of 20 µm to 40 µm, and T is in a range of 0.3 mm to 1.4 mm.

In some embodiments, doped semiconductor layers and TCO layers are sequentially disposed on the first face and the second face of the substrate structure layer along a direction away from the substrate structure layer, so that a thickness of the TCO layer on the first face of the substrate structure layer is M to form a first TCO thinning layer, and/or a thickness of the TCO layer on the second face of the substrate structure layer is M to form a second TCO thinning layer.

In some embodiments, the method further comprises, between step 31 and step 32, a step 33 of disposing an isolation layer on a surface of the doped semiconductor layer.

In some embodiments, the method further comprises, between step 31 and step 32, step S34 of cleaning to remove metal particles adhered to the doped semiconductor layer.

In some embodiments, the steps S11 and S12 are replaced a step S21 of forming a first mask layer with mask openings on the first face and/or the second face of the solar cell substrate.

In some embodiments, the isolation layer only covers the defect pits on the TCO layer, or the isolation layer is a new layer formed on the TCO layer while covering the defect pits.

Another object of the invention is to provide a solar cell prepared by the preparing method.

The preparing method of an embodiment of the invention has the following advantages compared with the conventional art:
(1) in an embodiment of the invention, the second mask layer is formed on the edge of the solar cell substrate, and the edge of the solar cell substrate at least includes all sidewalls of the solar cell substrate. The second mask layer avoids all the sidewalls of the solar cell substrate from being in a bare state, avoids damage to the sidewalls of the solar cell substrate in the process of electroplating to prepare the metal grid lines, and can improve the efficiency and yield of the prepared solar cell. In particular, in the process of preparing the bifacial electrode solar cell, the second mask layer forms an insulating area on the sidewalls of the solar cell substrate, and can prevent short circuit caused by local interconnection of the bifacial electrode solar cell.
(2) In an embodiment of the invention, the isolation layer is provided, so that the seed layer is prevented from diffusing into the solar cell substrate through the doped semiconductor layer, the problem of loss of electrical performance of the solar cell is avoided, and the efficiency of the prepared solar cell is improved.
(3) In disposed, the anti-oxidation layer is obtained on the metal grid lines by using a chemical displacement reaction, the anti-oxidation layer can be directly formed on the top and the sidewall of the metal grid lines, and the metal grid lines can be better prevented from being damaged in subsequent processes and in use.
(4) The fine mask openings with widths of N are formed by printing and developing, and the metal grid lines with widths of N are formed in the mask openings by electroplating, so that the spacing between adjacent metal grid lines on the same TCO layer can be reduced, that is, the number of metal grid lines on the same TCO layer is increased, and the light shielding area of all the metal grid lines on the same TCO layer is not enlarged. Because the spacing between adjacent metal grid lines is reduced, the conductivity of all the metal grid lines on the same TCO layer is improved, so that the thickness of the TCO layer can be reduced. Therefore, when the solar cell is prepared, the thickness of the TCO layer is M to form a TCO thinning layer, and then metal grid lines are electroplated on the TCO thinning layer according to the thickness of the TCO thinning layer, the widths of the metal grid lines on the TCO thinning layer are controlled to be N, and the spacing between adjacent metal grid lines on the TCO thinning layer is T. Thus, the thickness of the TCO layer is reduced, the preparation cost of the solar cell is saved, and the efficiency of the prepared solar cell is maintained or improved.

### BRIEF DESCRIPTION OF DRAWINGS

FIG. 1 is a schematic diagram of a division of areas on surfaces of a solar cell substrate;
FIG. 2 is a schematic diagram of a division of areas on surfaces of a solar cell substrate including an F area;
FIG. 3 is a schematic diagram of overlapping parts of a first mask layer and a second mask layer;
FIG. 4 is a schematic diagram of a width dimension of a second mask layer;
FIG. 5 is a schematic diagram of a first kind of coating process of a second mask material;
FIG. 6 is a schematic diagram of a second kind of coating process of a second mask material;
FIG. 7 is a schematic diagram of the cross section of a solar cell substrate after the first mask layer and the second mask layer are coated;
FIG. 8 is a schematic diagram of the cross section of a solar cell substrate after the second mask layer is dissolved;
FIGS. 9a-9g are schematic diagrams of the cross section of a bifacial electrode solar cell in the preparation process in a first specific example;
FIGS. 10a-10g are schematic diagrams of the cross section of a bifacial electrode solar cell in the preparation process in a first specific example;
FIGS. 11a-11g are schematic diagrams of the cross section of a monofacial electrode solar cell in the preparation process in a second specific example;
FIGS. 12a-12g are schematic diagrams of the cross section of a monofacial electrode solar cell in the preparation process in a second specific example;
FIGS. 13a, 13d and 13e are schematic diagrams of the cross section of a bifacial electrode solar cell substrate after a first mask layer is provided in three preferred examples, respectively;
FIGS. 13b and 13c are schematic diagrams of the size of a bifacial electrode solar cell substrate after a first mask layer is provided in two preferred examples, respectively;
FIGS. 14a-14b are schematic diagrams of substrate structure layers in two preferred examples, respectively;
FIGS. 15a-15b are schematic diagrams of the flow direction of the coating of a second mask material in two preferred examples, respectively;
FIGS. 16a-16b are schematic diagrams of a coating guiding mechanism in two preferred examples, respectively;
FIG. 17 is a schematic diagram of a process for forming an isolation layer in a first specific example;
FIG. 18 is a schematic diagram of a process for forming an isolation layer in a second specific example;
10 - solar cell substrate, 11 - substrate structure layer, 111 - crystalline silicon substrate layer, 112 - intrinsic semiconductor layer, 113 - film tunneling layer, 12 - doped semiconductor layer, 13 - TCO layer, 131 - defect pits, 132 - isolation layer, 14 - seed layer, 15 - conductive layer, 20 - first mask layer, 21 - first inclined thinning layer, 22 - mask opening, 30 - second mask layer, 31 - second inclined thinning layer, 40 - metal grid line, 210 - "U" type groove, 220 - feed pipe, 230 - blocking piece, 240 - discharge pipe.

### DETAILED DESCRIPTION

The preferred embodiments of the invention will be described in detail below with reference to the accompanying drawings, so that the advantages and features of the invention can be understood more easily by those skilled in the art. It should be noted that the description of the embodiments is used to help understand the invention, but does not constitute a limitation on the invention.

As the structure of crystalline silicon solar cells were developed to high open voltage, low temperature processes in every aspects have been applied more and more. Taking silicon-based heterojunction cells as an example, materials deposited on a solar cell substrate in sequence at low temperature are intrinsic amorphous silicon layer, doped amorphous silicon layer and transparent conductive oxide layer (TCO layer). The deposition method of amorphous silicon layer is usually plasma enhanced chemical vapor deposition (PECVD), and the deposition method of TCO layer is physical vapor deposition such as magnetron sputtering or reactive plasma deposition. In the deposition of a material from gas phase to solid phase, a thickness direction of the solar cell substrate, i.e. the sidewalls, will be inevitably deposited by the material. Since the light-receiving surface and the back surface of the bifacial electrode solar cell are two polarities of the cell, it is crucial to form an insulation area on the sidewalls or the edge of the surface to prevent short circuit caused by the local interconnection of the two polarities.

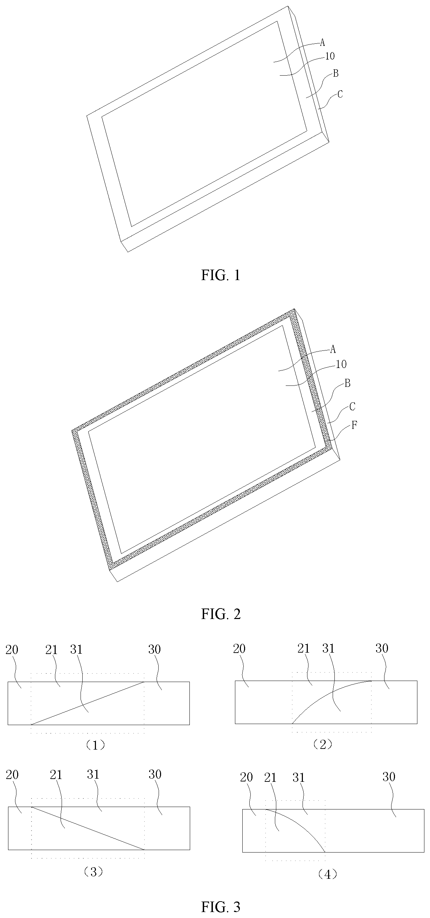

On the other hand, in a process of preparing the metal grid lines by electroplating, when the solution containing metal ions contacts the sidewalls of the solar cell substrate, metal will also be deposited on the sidewalls in the electroplating process, so it is usually needed to remove the deposited metal from the sidewalls of the solar cell substrate by etching-back, thereby reducing occurrence of sidewall short circuit. However, the etching-back often damages the sidewalls of the solar cell substrate, thereby affecting the efficiency and yield of the prepared solar cell. In the electroplating process, if the sidewalls of the solar cell substrate are not protected at all, the metal deposited on the sidewalls of the solar cell substrate is almost as thick as the metal deposited on the surfaces of the solar cell substrate. The metal deposited on the sidewalls of the solar cell substrate is removed by etching-back, and the metal deposited on the surface of the solar cell substrate will also be etched at the same time, so that the etching-back method cannot be used unless the metal deposited on the surfaces of the solar cell substrate is protected in the etching-back process. Based on this, the embodiment of the invention provides a cell preparation method, which improves the production process of the solar cell and avoids depositing metal on the sidewalls of the solar cell substrate. Referring to FIG. 1, surfaces of the solar cell substrate 10 is divided into three areas A, B and C, a first face of the solar cell substrate 10 is composed of the A area and the B area, the B area is adjacent to the edge of the first face of the solar cell substrate 10, the B area is annular, the annular here includes a shape of ' 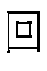 ', the B area surrounds the A area, and the C area is the entire sidewalls of the solar cell substrate 10. In the conventional art, a first mask layer 20 is generally coated on the whole first face of the solar cell substrate 10, and then the metal grid lines 40 are prepared with the assistance of the first mask material. However, the entire sidewalls of the solar cell substrate 10 are exposed, and the sidewalls of the solar cell substrate 10 will be damaged in the process of preparing the metal grid lines 40 by electroplating, thereby affecting the efficiency and yield of the prepared solar cell.

### Embodiment 1

A preparation method for a solar cell includes the following steps:
S11, forming a first mask layer 20 on a first face and/or a second face of a solar cell substrate 10.

The first face and the second face are two opposite surfaces of the solar cell substrate 10. The solar cell substrate 10 comprises at least a substrate structure layer 11, a doped semiconductor layer 12 and a TCO layer 13 (full name of TCO is transparent conductive oxide) in sequence from inside to outside. The outermost layer of the first face and/or the second face of the solar cell substrate 10 may be the TCO layer 13. The first mask layer 20 is formed on the TCO layer 13. The TCO layer 13 comprises one or two of indium tin oxide (ITO), Tungsten-doped indium oxide (IWO), zinc oxide doped with aluminum (ZnO_{z}Al), zinc oxide doped with gallium (ZnO_{z}GA) and Zn-in-Sn-O (ZITO). In a preferred embodiment, the outermost layer of the first face of the solar cell substrate 10 is a seed layer 14, and the outermost layer of the second face of the solar cell substrate 10 is a seed layer 14 or a conductive layer 15. That is, the seed layer 14 or the conductive layer 15 is arranged on the outside of the TCO layer 13, and the first mask layer 20 is formed on the seed layer 14 or the conductive layer 15. When the outermost layers of the first face and the second face of the solar cell substrate 10 are both the seed layers 14, first mask layers 20 are formed on the seed layers 14 located in the outermost layers of the first face and the second face when the solar cell substrate 10 is a substrate with bifacial electrodes. When the outermost layer of the first face of the solar cell substrate 10 is the seed layer 14, and the outermost layer of the second face of the solar cell substrate 10 is the conductive layer 15, the first mask layers 20 are respectively formed on the seed layer 14 located in the outermost layer of the first face and the conductive layer 15 located in the outermost layer of the second face when the solar cell substrate 10 is a substrate of a monofacial electrode solar cell. As can be seen, the outermost layer of the solar cell substrate 10 comprises at least one of the TCO layer 13, the seed layer 14 and the conductive layer 15.

Preferably, the seed layer 14 can be coated on the first face and/or the second face of the solar cell substrate 10 by electroplating. The seed layer 14 can be an activation layer made of at least one of aluminum, nickel, and palladium, or a TiW material layer or a TiN material layer. The TiW material layer or the TiN material layer is usually obtained by magnetron sputtering. When the seed layer 14 is provided on both the first face and the second face of the solar cell substrate 10, the solar cell substrate 10 is a substrate of a bifacial electrode solar cell, such as a substrate of a heterojunction cell. For example, as shown in FIG. 1, the seed layer 14 completely covers the A area and the B area. When the solar cell substrate 10 is horizontally placed, the first face is the upper face or the lower face of the solar cell substrate 10, and the second face is the lower face or the upper face of the solar cell substrate 10, respectively. The seed layer 14 includes a single metal layer, a single metal alloy layer, or a multilayer structure of at least two different single layers. For example, the seed layer 14 can be made of copper, tin, cobalt, nickel, silver, tin-lead alloy, tin-silver alloy, copper-nickel alloy, copper-chromium alloy, copper-ruthenium alloy, copper-rhodium alloy, copper-silver alloy, copper-iridium alloy, copper-palladium alloy, copper-platinum alloy, copper-gold alloy, and copper-rare earth alloy, copper-nickel-silver alloy, or copper-nickel-rare earth metal alloy. Preferably, the seed layer 14 is made of copper, copper-nickel alloy, copper-tin alloy, copper-ruthenium alloy, or copper-rhodium alloy.

Preferably, the first mask layer 20 can be obtained by coating or deposition. When the first mask layer 20 is prepared on the seed layer 14 by coating, drying is required. According to the thickness and material of the first mask layer 20, the drying time can be predermined in the range of 5-15 minutes. The material of the first mask layer 20 is photosensitive resin, which includes one or a mixture of epoxy resin, acrylic resin, phenolic resin, novolac resin, melamine resin, and polyurethane resin. The photosensitive resin may also be organic materials such as benzocyclobutene, poly-p- dimethyl phenylene, flare, polyimide, etc. The positive photosensitive material may be photosensitive material including novolac resin and naphthoquinone diazide compound as a photosensitizer. The negative photosensitive material can be photosensitive material including base resin, diphenylsilandiol, and oxygen generator, etc.

Specifically, the first mask layer 20 is formed by using a coating mechanism, which includes a coating platform, a coating mold, and a scraper. The coating mold is provided with coating holes matching the size of the solar cell substrate 10. Step S11 specifically includes:
S111, placing the solar cell substrate 10 on the coating platform so that the first face of the solar cell substrate 10 faces upward;
S112, placing the coating mold (which can be a screen) on the first face of the solar cell substrate 10 and aligning the coating holes of the coating mold with the solar cell substrate 10;
S113, coating the first mask material on the first face of the solar cell substrate 10 in the coating holes;
S114, using the scraper to level the coated first mask material;
S115, drying the flattened first mask material to form a first mask layer 20;
S116, repeating steps S111-S115 to form the first mask layer 20 on the second face of the solar cell substrate 10.

In order to avoid the liquid first mask material from falling on the coating platform during the coating process, the size of the coating hole is slightly smaller than the size of the solar cell substrate 10, that is, the boundary of the coating hole is kept within the face of the solar cell substrate 10, and the boundary of the coating hole does not exceed the edge of the solar cell substrate 10. For example, the size of the solar cell substrate 10 is 166 mm × 166 mm × 130 µm, and the size of the coating hole is 160 mm × 160 mm × 140 µm.

S12, forming a mask opening 22 on the first mask layer 20.

Preferably, mask openings 22 are formed on the first mask layer 20 by illuminating part of the first mask layer 20 to cause a chemical reaction, removing the part of the first mask layer 20 where the chemical reaction occurs, or removing the part of the first mask layer 20 where the chemical reaction does not occur. The illuminating of part of the first mask layer 20 to cause a chemical reaction is called printing, and the removal of the part of the first mask layer 20 where the chemical reaction occurs or the part of the first mask layer 20 where the chemical reaction does not occur is called developing. The purpose of printing and developing is to obtain the mask openings 22. Those skilled in the art should know that the mask openings 22 penetrate the first mask layer 20, and the bottom of the mask openings 22 are the TCO layer 13 or the seed layer 14. The purpose of forming the mask openings 22 is to expose the TCO layer 13 or the seed layer 14. The printing and developing processes can obtain mask openings 22 with a narrower width, and subsequent electroplating can obtain metal grid lines 40 with a narrower width, thereby improving the efficiency of the prepared solar cell.

S13, a second mask layer 30 is formed on the edge of the solar cell substrate 10, wherein the edge of the solar cell substrate 10 at least includes all the sidewalls of the solar cell substrate 10. The second mask layer 30 is made of a thermosetting resin. The thermosetting resin can be silicone resin, polyamide resin, polyolefin resin, cyanate resin, phenolic resin, naphthalene resin or fluorene resin. The solar cell substrate 10 is in a thin sheet structure, and the shape of the solar cell substrate 10 may be regarded as a rectangle or a rectangle with at least one chamfered corner. When the solar cell substrate 10 is a rectangle with four rounded corners, all the sidewalls of the solar cell substrate 10 include four plane sidewalls and four arc sidewalls. When the solar cell substrate 10 is a rectangle with four right-angled chamfered corners, all the sidewalls of the solar cell substrate 10 include eight plane sidewalls. When the solar cell substrate 10 is a rectangle with two rounded corners, all the sidewalls of the solar cell substrate 10 include four plane sidewalls and two arc sidewalls. When the solar cell substrate 10 is a rectangle, all the sidewalls of the solar cell substrate 10 include four plane sidewalls. In the embodiment and subsequent embodiments, the shape of the solar cell substrate 10 can be schematically regarded as a rectangle or a square, which is only for the convenience of describing the principle of the application. In actual production, the shape of the solar cell substrate 10 is more like a rectangle with four chamfered corners.

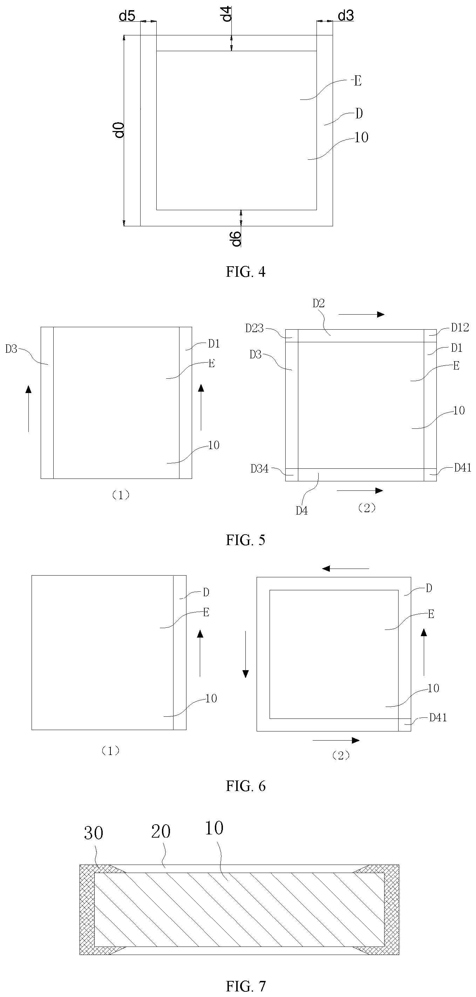

The second mask layer 30 is formed on the edge of the solar cell substrate 10, and the purpose is to protect the edge of the solar cell substrate 10. The edge protection means that the edge of the solar cell substrate 10 is covered, that is, the second mask layer 30 is formed on the edge of the solar cell substrate 10, so as to avoid metal deposited on the sidewalls of the solar cell substrate 10 in the subsequent electroplating process. If the second mask layer 30 is only coated on the entire sidewalls of the solar cell substrate 10, the second mask layer 30 will fall off easily, and it is easier to produce a gap at the joint of the second mask layer 30 and the first mask layer 20, through which the outermost layer of the solar cell substrate 10 will be corroded. Therefore, a continuous second mask layer 30 would be formed on the entire sidewalls and the edges of the upper and lower faces of the solar cell substrate 10. An analogue of the second mask layer 30 is an shell with open upper and lower ends, which can wrap the solar cell substrate 10 therein and expose the first face and the second face. Generally, an analogue of the second mask layer 30 is a shoe cover with an open bottom, which can wrap the solar cell substrate 10 therein and expose the first face and the second face, thereby reducing the risk of falling off of the second mask layer 30. Further, as shown in FIG. 7, the section of the second mask layer 30 along the up-down direction (or the thickness direction of the solar cell substrate 10) is a "C" type, and the "C" type structure can wrap the solar cell substrate 10, thereby reducing the risk of falling off of the second mask layer 30. In addition, the second mask layer 30 and the first mask layer 20 are coated at the joint of the second mask layer 30 and the first mask layer 20, thereby avoiding the problem that the gap is easy to appear at the joint of the second mask layer 30 and the first mask layer 20. The second mask layer 30 can be obtained by coating, and needs to be dried after coating. According to the thickness and material of the second mask layer 30, the drying time can be selected and predetermined in the range of 1-5 minutes.

Taken FIG. 1 as example, the first mask layer 20 covers the whole A area on the first face of the solar cell substrate 10, and at least covers part of the B area on the first face of the solar cell substrate 10. The second mask layer 30 covers the whole C area, and at least covers part of the B area on the first face of the solar cell substrate 10; and the first mask layer 20 and the second mask layer 30 overlap in the B area on the first face of the solar cell substrate 10, so as to avoid the problem that the outermost layer of the solar cell substrate 10 is corroded due to a gap between the second mask layer 30 and the first mask layer 20. The area covered by the second mask layer 30 is a continuous area, and the area covered by the first mask layer 20 on the first face of the solar cell substrate 10 is a continuous area. The edge of the solar cell substrate 10 at least includes the C area, and can include the whole or part of the B area. Preferably, the overlapping part of the first mask layer 20 and the second mask layer 30 in the B area forms an annular shape, wherein the annular shape includes a shape of ' 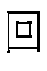 ', for example, the F area shown in FIG. 2. One boundary of the F area coincides with the edge of the face of the solar cell substrate 10, and the other boundary of the F area coincides with the edge of the A area or is located in the B area. Referring to FIG. 3, in the first drawing of FIG. 3, the second mask layer 30 is coated on the first face of the solar cell substrate 10, the thickness of an edge of the second mask layer 30 gradually decreases and to the edge tilts toward the face of the solar cell substrate 10, thereby forms a second inclined thinning layer 31, and then the first mask layer 20 is coated on the first face of the solar cell substrate 10, the first mask layer 20 and the second mask layer 30 partially overlap, and the part of the first mask layer 20 that overlapping with the second inclined thinning layer 31 forms a first inclined thinning layer 21, the first inclined thinning layer 21 is a thickness thinning layer of the first mask layer 20 and tilts away from the surface of the solar cell substrate 10. In the first drawing of FIG. 3, the second inclined thinning layer 31 is a bevel structure, and the first inclined thinning layer 21 is a bevel structure matched with the second inclined thinning layer 31. In the second drawing of FIG. 3, the second inclined thinning layer 31 is a cambered surface structure, and the first inclined thinning layer 21 is a cambered surface structure matched with the second inclined thinning layer 31. In the third drawing of FIG. 3, the first mask layer 20 is coated on the first face of the solar cell substrate 10, the thickness of the edge of the first mask layer 20 gradually decreases and the edge tilts toward the surface of the solar cell substrate 10, thereby forming a first inclined thinning layer 21, and then the second mask layer 30 is coated on the first face of the solar cell substrate 10, the second mask layer 30 and the first mask layer 20 partially overlap, and the part of the second mask layer 30 that overlapping with the first inclined thinning layer 21 forms a second inclined thinning layer 31, the second inclined thinning layer 31 is a thickness thinning layer of the second mask layer 30 and tilts away from the face of the solar cell substrate 10.In the third drawing of FIG. 3, the first inclined thinning layer 21 is a bevel structure, and the second inclined thinning layer 31 is a bevel structure matched with the first inclined thinning layer 21. In the fourth drawing of FIG. 3, the first inclined thinning layer 21 is a cambered surface structure, and the second inclined thinning layer 31 is a cambered surface structure matched with the first inclined thinning layer 21. The first inclined thinning layer 21 and the second inclined thinning layer 31 overlap to form an overlapping part of the first mask layer 20 and the second mask layer 30 in the B area. The first inclined thinning layer 21 is a bevel structure or a cambered surface structure, and the second inclined thinning layer 31 is a bevel structure or a cambered surface structure matched with the first inclined thinning layer 21. Through contact matching of the two bevel structures or the two cambered surface structures, the contact area is enlarged, so that the first mask layer 20 and the second mask layer 30 can be firmly combined together, and the risk of cracking at the combined part of the first mask layer 20 and the second mask layer 30 is reduced.

In other embodiments, when the solar cell is a bifacial electrode solar cell, the second face of the solar cell substrate 10 is composed of an A area and a B area, and the B area is adjacent to the edge of the second face. On the second face, the B area is annular, and the B area surrounds the A area. The first mask layer 20 covers all the A area on the second face and at least covers part of the B area on the second face. The second mask layer 30 at least covers part of the B area on the second face, and the first mask layer 20 and the second mask layer 30 partially overlap in the B area on the second face. The technical solutions of the first face of the solar cell substrate 10 can also be applied to the second face of the solar cell substrate 10.

As shown in FIG. 4, on the first face of the solar cell substrate 10 (the face where metal grid lines 40 are electroplated on), an area E is formed by the coated first mask material, and an area D is formed by the coated second mask material. The areas E and D cover the entire first face of the solar cell substrate 10. The solar cell substrate 10 is square-shaped, which has a side length d0, and the value of d0 can be 156.75mm, 158.75mm, 166mm, 182mm, or 210mm. The coated second mask material forms four edge strip areas along the periphery of the first face: the first, second, third, and fourth edge strips with widths d3, d4, d5, and d6 respectively. These widths range from 0.2-5mm, preferably 0.3-1mm, thereby the widths of the areas formed by the coated second mask material along the edges of the first face will not be too small resulting in the second mask material easily falling off, meanwhile, the widths of the areas formed by the coated second mask material along the edges of the first face will not be too large resulting difficulty in subsequent removal of the second mask material. Preferably, the minimum value among d3, d4, d5, and d6 should be not less than 0.2mm and the maximum value among them should be not more than 5mm, thereby the widths of the areas formed by the coated second mask material along the edges of the first face will not be too small resulting in the second mask material easily falling off, meanwhile, the widths of the areas formed by the coated second mask material along the edges of the first face will not be too large resulting difficulty in subsequent removal of the second mask material. Preferably, the width values of d3, d4, d5, and d6 relate to d0, and the ration of each of d3, d4, d5, and d6 to d0 maintained between 0.1%-3%, thereby the widths of the areas formed by the coated second mask material along the edges of the first face will not be too small resulting in the second mask material easily falling off, meanwhile, the width of the areas formed by the coated second mask material along the edges of the first face will not be too large resulting difficulty in subsequent removal of the second mask material. In the embodiment, the area D can be the area F in FIG. 2, and the area E can be a single-layer of first mask material covering area. When the second face of the solar cell substrate 10 is also a face on which the metal grid lines 40 are electroplated, the above technical solution can also be applied, and in this case, the cell is a bifacial electrode solar cell.

It should be noted that the first edge strip area, the second edge strip area, the third edge strip area and the fourth edge strip area can be rectangular areas, or can be rectangles with rounded corners or right-angled corners.

For example, as shown in FIG. 5, the left and right edges of the first face of the solar cell substrate 10 are coated to form the first edge strip area D1 and the third edge strip area D3, and the upper and lower edges of the first face of the solar cell substrate 10 are coated to form the second edge strip area D2 and the fourth edge strip area D4. The first edge strip area D1 intersects with the second edge strip area D2, and the intersection area is D12. The first edge strip area D1 intersects with the fourth edge strip area D4, and the intersection area is D41. The third edge strip area D3 intersects with the second edge strip area D2, and the intersection area is D23. The third edge strip area D3 intersects with the fourth edge strip area D4, and the intersection area is D34. This ensures that the seam of the second mask layer 30 can be completely closed to form an annular shape during its preparation process, and the metal ions can be prevented from penetrating from the seam to the outermost layer of the solar cell substrate 10 and the sidewalls of the solar cell substrate 10 during the subsequent electroplating process. The outermost layer of the solar cell substrate 10 can also be prevented from being corroded from the seam. When the second face of the solar cell substrate 10 is also a face for electroplating the metal grid lines 40, the above technical solution can also be applied. In this case, the cell is a bifacial electrode solar cell.

As shown in FIG. 6, the second mask material is coated on the edges of the first face of the solar cell substrate 10 in a counterclockwise direction to form the area D. The area D is an annular shape, and the area D has only one intersection area, which is D41. In other embodiments, the second mask material can also be coated on the edges of the first face of the solar cell substrate 10 in a clockwise direction to form the area D. The area D has only one intersection area, the area of the intersection area is small, thus the subsequent removal of the second mask material is facilitated, the area D is formed continuously at one time, and the efficiency is higher. When the second face of the solar cell substrate 10 is also a face for electroplating the metal grid lines 40, the above technical solution can also be applied. In this case, the cell is a bifacial electrode solar cell.

In other embodiments, the second mask material can be coated on three edges of the first face of the solar cell substrate 10 in a counterclockwise (or clockwise) direction firstly, and then the second mask material is coated on the fourth edge of the first face of the solar cell substrate 10 to form a closed annular area D.

S14. Electroplating to form the metal grid lines 40 in the mask openings 22.

Preferably, the material of the metal grid lines 40 can be any one of copper, tin, silver, and zinc and an alloy thereof, and the metal grid lines 40 can also be a stack of any two or more layers of copper, tin, silver, and zinc. Preferably, the metal grid lines 40 are grid lines with a width gradient, that is, the metal grid lines 40 are divided into multiple layers distributed from top to bottom. All the layers of the metal grid lines 40 include a top layer located at the top, and at least one width expansion layer exists below the top layer. The width of the width expansion layer is larger than the width of any layer above it.

S15. Removing the first mask layer 20 and the second mask layer 30.

Preferably, when the seed layer 14 is arranged on the solar cell substrate 10, the step S15 comprises: firstly, removing the first mask layer 20 and the second mask layer 30, and then etching and removing the seed layer 14 on the solar cell substrate 10; specifically, the seed layer 14 in the spaces between the metal grid lines 40 needs to be etched and removed, and the seed layer 14 connected to the TCO layer 13 at the root of the metal grid lines 40 needs to be reserved.

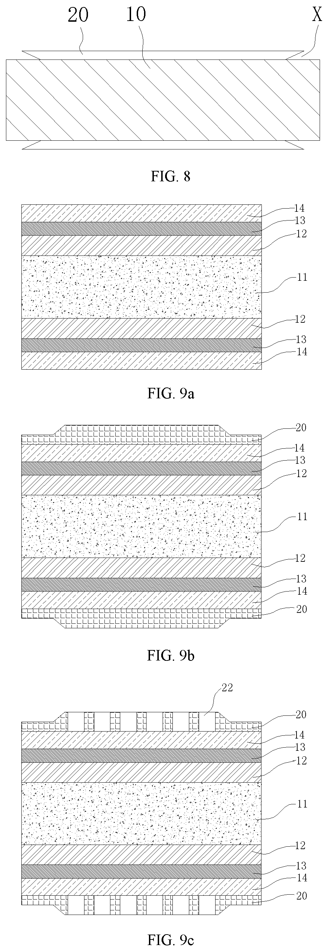

Specifically, the first mask layer 20 and the second mask layer 30 can be removed by soaking or spraying an alkaline solution, such as a NaOH solution; because the volume of the first mask layer 20 is much larger than that of the second mask layer 30, the second mask layer 30 is dissolved by soaking or spraying the alkaline solution, and the first mask layer 20 is foamed and swelled to be separated from the solar cell substrate 10 by soaking or spraying the alkaline solution, without dissolving the first mask layer 20, such that the efficiency of removing the first mask layer 20 can be improved, and the usage of the alkaline solution can be reduced. The first mask layer 20 separated from the solar cell substrate 10 is removed by filtering. When the solar cell substrate 10 comprises the seed layer 14, after the first mask layer 20 and the second mask layer 30 are removed, the solar cell will be cleaned (e.g. washed with water) and dried, and then soaked in an acid solution to etch and remove the seed layer 14, wherein the acid solution can be a sulfuric acid solution. As shown in FIG. 8, after the second mask layer 30 is dissolved, a dissolution gap X is formed between the first mask layer 20 and the seed layer 14, and the edge of the first mask layer 20 in contact with the seed layer 14 can directly contact the alkaline solution through the dissolution gap X, so that the foaming and swelling process of the first mask layer 20 can be accelerated, and the first mask layer 20 can be quickly separated from the solar cell substrate 10.

Preferably, when the metal grid lines 40 are made of an oxidizable metal, an anti-oxidation layer is provided on the surface of the metal grid lines 40; the anti-oxidation layer can be a metal, such as tin or silver which is not easy to be oxidized, and an alloy thereof or an organic anti-oxidation layer. The anti-oxidation layer can be obtained by electroplating (e.g. electroplating tin), or a tin protective layer or an organic anti-oxidation layer wrapping the whole metal grid lines 40 (e.g. copper grid lines) by a chemical displacement reaction. More preferably, this step is performed after the step S14 and before the step S 15, so as to avoid the oxidation damage of the metal grid lines 40 in the step S15; in this case, the anti-oxidation layer is formed before the first mask layer 20 is removed, and if the anti-oxidation layer is obtained by electroplating, the anti-oxidation layer can only form a protective layer on the top of the metal grid lines 40 due to the blocking of the first mask layer 20, and cannot form any protective layer on the sidewalls of the metal grid lines 40, and when the first mask layer 20 is removed, the sidewalls of the metal grid lines 40 is still exposed and is easy to be oxidized and corroded, so the anti-oxidation layer can be further formed on the sidewalls of the metal grid lines 40; and if the anti-oxidation layer is obtained by a chemical displacement reaction, the anti-oxidation layer can be directly formed on the top and the sidewalls of the metal grid lines 40, so that the damage of the metal grid lines 40 in the step S15, especially the damage of the sidewalls of the metal grid lines 40 in the step S15, can be better avoided.

In a first specific example, the edge protection process in step S13 can be performed after step S11 and before step S 14. That is, the first mask material is coated on the outermost layer of the solar cell substrate 10, and after drying, the first mask layer 20 is formed; and then the second mask material is coated on the edge and the sidewalls of the solar cell substrate 10, and after drying, the second mask layer 30 is formed. In this example, the first mask layer 20 has undergone two drying processes, so that the first mask layer 20 is deeply attached to the outermost layer of the solar cell substrate 10, and the first mask layer 20 is not easy to be removed. However, coating the first mask material on the outermost layer of the solar cell substrate 10 firstly can protect the outermost layer of the solar cell substrate 10, avoid the outermost layer of the solar cell substrate 10 from being oxidized in the drying process, and thus improve the efficiency of the prepared cell.

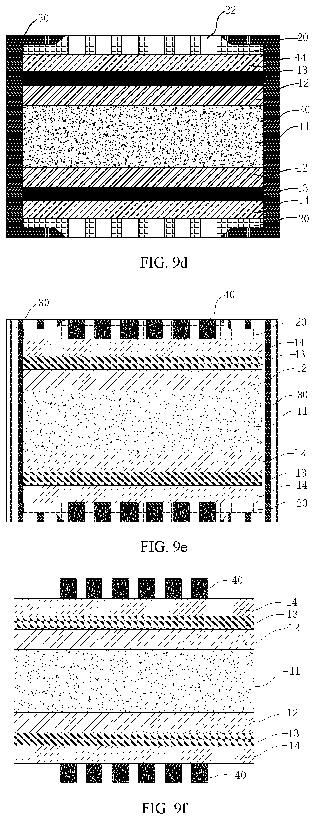

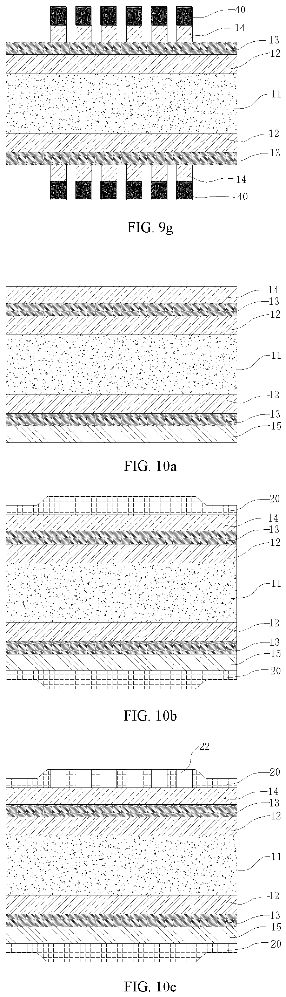

FIGS. 9a-9g are sectional schematic diagrams of the bifacial electrode solar cell in the preparation process in the first specific example. As shown in FIG. 9a, the solar cell substrate 10 of the bifacial electrode solar cell includes a substrate structure layer 11, and a doped semiconductor layer 12, a TCO layer 13 and a seed layer 14 are sequentially disposed on the first and second faces of the substrate structure layer 11 in a direction away from the substrate structure layer 11. The first and second faces of the substrate structure layer 11 are two opposite faces. Preferably, the substrate structure layer 11 includes an N-type semiconductor layer (N-Si), the doped semiconductor layers 12 on the first and second faces of the substrate structure layer 11 are a P-type microcrystalline silicon layer (uc-Si(p)) and an N-type microcrystalline silicon layer (uc-Si(n)) respectively, the TCO layer 13 is an ITO layer, and the seed layer 14 is a PVD Cu layer, wherein PVD Cu refers to a physical vapor deposition copper layer. The seed layers 14 on the first and second faces of the substrate structure layer 11 are coated to form first mask layers 20 respectively, and a structure as shown in FIG. 9b is obtained. Preferably, the thickness of the first mask layer 20 is thin at the periphery and thick in the middle. The first mask layers 20 on the first and second faces of the substrate structure layer 11 are printed and developed to form mask openings 22 thereon, and a structure as shown in FIG. 9c is obtained. The mask openings 22 are all formed on the middle of the first mask layer 20, and no mask opening 22 is disposed on the periphery of the first mask layer 20, so that a situation that the mask openings 22 on the periphery of the first mask layer 20 are covered by the subsequent second mask layer 30 can be avoid. Preferably, the thickness of the first mask layer 20 is thin at the periphery and thick in the middle, the mask openings 22 are disposed on the middle protrusion of the first mask layer 20, the thinned portion of the periphery of the first mask layer 20 is matched with the second mask layer 30, the thinned portion of the periphery of the first mask layer 20 can guide the flow of the coated second mask material, and the preparation of the second mask layer 30 is facilitated. All the sidewalls of the solar cell substrate 10 and four edges of the first mask layers 20 on the two faces of the substrate structure layer 11 are coated to form the second mask layers 30, and a structure as shown in FIG. 9d is obtained. The second mask layers 30 respectively form a ' 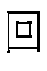 ' shaped structure on the first mask layers 20 on the two faces of the substrate structure layer 11, and the cross section of the second mask layer 30 constitutes a "C" shape in the thickness direction. The metal grid lines 40 are formed in the mask openings 22 on the first and second faces of the substrate structure layer 11 by electroplating, and a structure as shown in FIG. 9e is obtained. The metal grid lines 40 are preferably copper grid lines and are electroplated with a metal tin layer thereon, and the metal tin layer covers the top of the copper grid lines. The first mask layers 20 and the second mask layers 30 are removed, and a structure as shown in FIG. 9f is obtained. The seed layers 14 on the first and second faces of the substrate structure layer 11 are etched and removed, the metal grid lines 40 are exposed, the solar cell is formed, and a structure as shown in FIG. 9g is obtained.

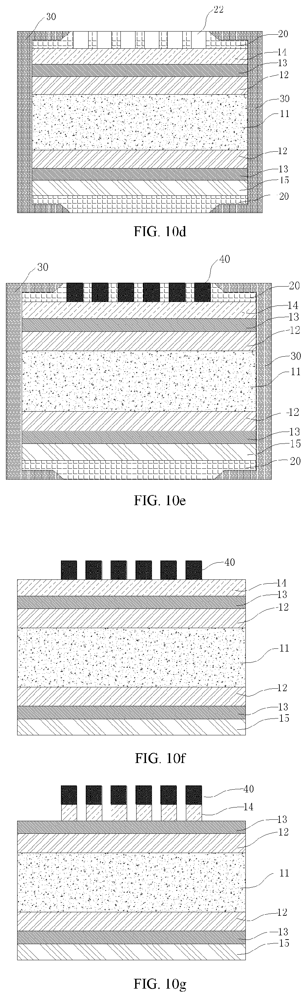

FIGS. 10a-10g are sectional schematic diagrams of the monofacial electrode solar cell in the preparation process in the first specific example. As shown in FIG. 10a, the monofacial electrode solar cell substrate 10 comprises a substrate structure layer 11, and a doped semiconductor layer 12 and a TCO layer 13 are sequentially arranged on a first face and a second face of the substrate structure layer 11 away from the substrate structure layer 11, a seed layer 14 is arranged on the TCO layer 13 on the first face, and a conductive layer 15 is arranged on the TCO layer 13 on the second face, and the first face and the second face of the substrate structure layer 11 are two opposite faces. Preferably, the substrate structure layer 11 comprises an N-type semiconductor layer (N-Si), the doped semiconductor layers 12 on the first face and the second face of the substrate structure layer 11 are a P-type microcrystalline silicon layer (uc-Si(p)) and an N-type microcrystalline silicon layer (uc-Si(n)) respectively, the TCO layer 13 is an ITO layer, and the seed layer 14 is a PVD Cu layer. The seed layer 14 and the conductive layer 15 are coated to form a first mask layer 20 respectively, and a structure as shown in FIG. 10b is obtained, and preferably, the first mask layer 20 is thick in the middle and thin at the periphery. The first mask layer 20 on the seed layer 14 is printed and developed to form mask openings 22 thereon, and a structure as shown in FIG. 10c is obtained, the mask openings 22 is formed on the middle of the first mask layer 20, and no mask openings 22 is arranged on the four-side edges of the first mask layer 20, so that a situation that the mask openings 22 on the four edges of the first mask layer 20 is covered by a subsequent second mask layer 30 can be avoided; preferably, the first mask layer 20 is thick in the middle and thin at the periphery, the mask openings 22 is arranged on the middle protrusion of the first mask layer 20, the thinning part of the four-side edges of the first mask layer 20 is matched with the second mask layer 30, the thinning part of the four-side edges of the first mask layer 20 can guide the flow of the coated second mask material, and the generation of the second mask layer 30 is facilitated. All the sidewalls of the solar cell substrate 10 and four edges of the first mask layer 20 on the two faces of the substrate structure layer 11 are coated to form the second mask layer 30, and a structure as shown in FIG. 10d is obtained, the second mask layer 30 forms a ' 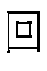 ' shaped structure on the first mask layer 20 on the two faces of the substrate structure layer 11 respectively, and the cross section of the second mask layer 30 constitutes a "C" shape in the thickness direction. The metal grid lines 40 are formed in the mask openings 22 on the first face of the substrate structure layer 11 by electroplating and a structure as shown in FIG. 10e is obtained, the metal grid lines 40 are preferably copper grid lines and metal tin layers are electroplated thereon, and the metal tin layers covers the top of the copper grid lines. The first mask layer 20 and the second mask layer 30 are removed, and a structure as shown in FIG. 10f is obtained; the seed layer 14 on the first side is etched and removed, the metal grid lines 40 are exposed, the solar cell is formed, and a structure as shown in FIG. 10g is obtained.

In a second specific example, the edge protection process in step S13 can be perfomed before step S11. That is, the second mask material is coated on the edge and the sidewalls of the solar cell substrate 10, and after drying, the second mask layer 30 is formed; and then the first mask material is coated on the outermost layer of the solar cell substrate 10, and after drying, the first mask layer 20 is formed. In this example, in the process of drying the second mask material, the outermost layer of the solar cell substrate 10 is in a bare state and is easy to be oxidized, resulting in a reduced efficiency of the prepared solar cell. Therefore, the process of drying the second mask material can be carried out in an inert gas protection environment to avoid oxidation of the outermost layer of the bare cell substrate 10. Compared with the first specific example, the first mask layer 20 coated on the outermost layer of the solar cell substrate 10 is only dried once, so that the first mask layer 20 is easy to be removed, and the production efficiency of the cell can be improved.

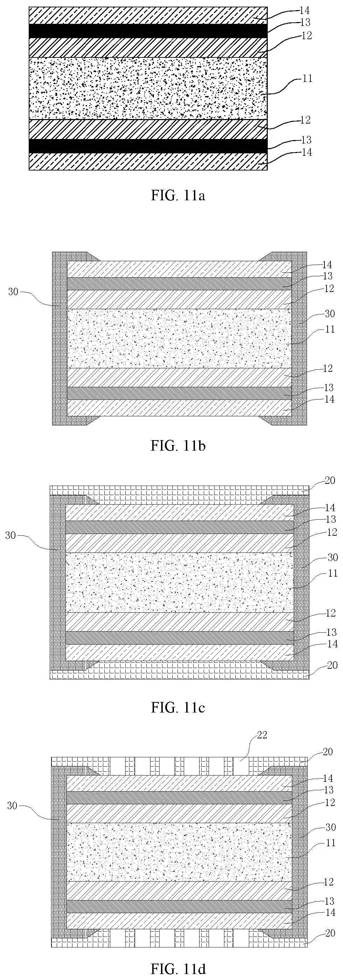

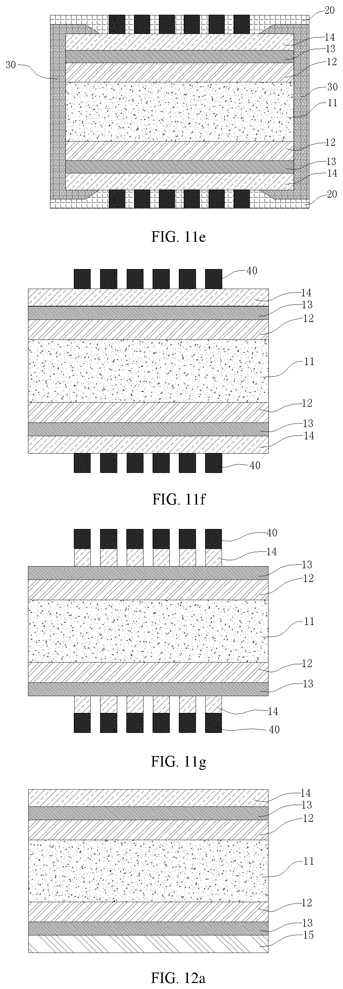

FIGS. 11a-11g are cross-sectional schematic diagrams of a bifacial electrode solar cell in the preparation process according to the second specific example. As shown in FIG. 11a, the solar cell substrate 10 of the bifacial electrode solar cell includes a substrate structure layer 11, and a doped semiconductor layer 12, a TCO layer 13 and a seed layer 14 are sequentially disposed on the first and second faces of the substrate structure layer 11 away from the substrate structure layer 11. The first and second faces of the substrate structure layer 11 are two opposite surfaces. Preferably, the substrate structure layer 11 includes an N-type semiconductor layer (N-Si), the doped semiconductor layers 12 on the first and second faces of the substrate structure layer 11 are a P-type microcrystalline silicon layer (uc-Si(p)) and an N-type microcrystalline silicon layer (uc-Si(n)) respectively, the TCO layer 13 is an ITO layer, and the seed layer 14 is a PVD Cu layer. A second mask layer 30 is coated on all the sidewalls of the solar cell substrate 10 and the four edges of the seed layer 14 on the two faces of the substrate structure layer 11 to obtain the structure as shown in FIG. 11b, and the second mask layer 30 forms a ' 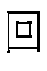 ' shaped structure on the seed layer 14 on the two faces of the substrate structure layer 11 respectively, and the cross section of the second mask layer 30 forms a "C" shape in the thickness direction. A first mask layer 20 is coated on the two faces of the substrate structure layer 11 respectively, the middle part of the first mask layer 20 is filled in the middle opening of the ' 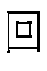 ' shaped structure and covers the seed layer 14, and the peripheral part of the first mask layer 20 covers the four edges of the ' 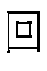 ' shaped structure to obtain the structure as shown in FIG. 11c. The first mask layer 20 on the first and second faces of the substrate structure layer 11 is printed and developed to form mask openings 22 thereon to obtain the structure as shown in FIG. 11d, the mask openings 22 are all formed on the first mask layer 20 covering the seed layer 14, and the mask openings 22 are not disposed on the overlapping part of the first mask layer 20 and the second mask layer 30 to avoid damaging the binding force between the first mask layer 20 and the second mask layer 30, and meanwhile, to reduce the risk of deformation of the mask openings 22 caused by multi-layer materials. The metal grid lines 40 are formed in the mask openings 22 on the two faces of the substrate structure layer 11 by electroplating to obtain the structure as shown in FIG. 11e, the metal grid lines 40 are preferably copper grid lines and metal tin layers are electroplated thereon, and the metal tin layers cover the top of the copper grid lines. The first mask layer 20 and the second mask layer 30 are removed to obtain the structure as shown in FIG. 11f. The seed layer 14 on the first and second faces of the substrate structure layer 11 is etched and removed to expose the metal grid lines 40, thereby forming a cell to obtain the structure as shown in FIG. 11g.

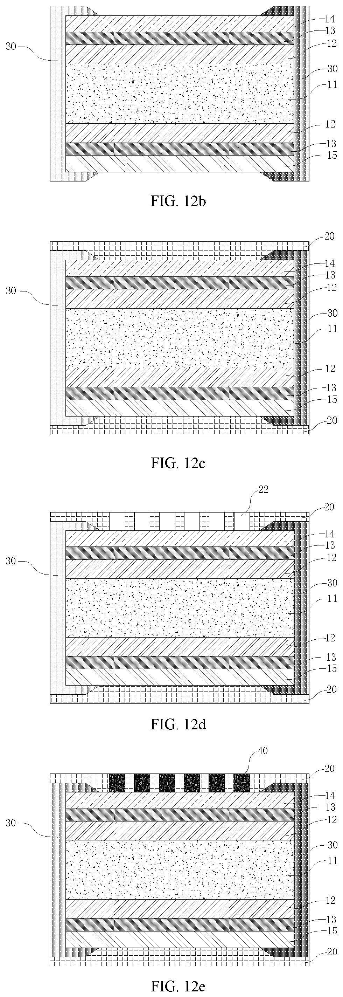

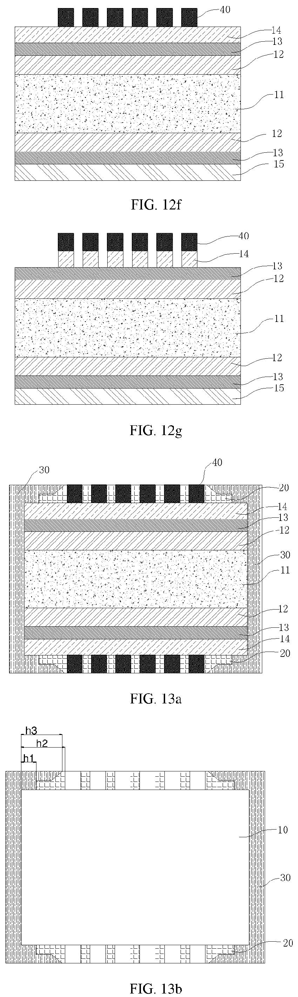

FIGS. 12a-12g are schematic sectional views of a monofacial electrode solar cell in the process of preparation in the second specific example. As shown in FIG. 12a, the solar cell substrate 10 of the monofacial electrode solar cell includes a substrate structure layer 11, and a doped semiconductor layer 12 and a TCO layer 13 are sequentially disposed on the first face and the second face of the substrate structure layer 11 away from the substrate structure layer 11. A seed layer 14 is disposed on the TCO layer 13 on the first face, and a conductive layer 15 is disposed on the TCO layer 13 on the second face. The first face and the second face of the substrate structure layer 11 are two opposite faces. Preferably, the substrate structure layer 11 includes an N-type semiconductor layer (N-Si), the doped semiconductor layers 12 on the first face and the second face of the substrate structure layer 11 are a P-type microcrystalline silicon layer (uc-Si(p)) and an N-type microcrystalline silicon layer (uc-Si(n)) respectively, the TCO layer 13 is an ITO layer, and the seed layer 14 is a PVD Cu layer. A second mask layer 30 is formed by coating on all the sidewalls of the solar cell substrate 10 and the four edges of the seed layer 14 and the conductive layer 15, obtaining the structure as shown in FIG. 12b. The second mask layer 30 forms a ' 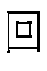 ' shaped structure on the seed layer 14 and the conductive layer 15 respectively, and the cross section of the second mask layer 30 forms a "C" shape in the thickness direction. A first mask layer 20 is formed by coating on the two faces of the substrate structure layer 11. On the first face of the substrate structure layer 11, the middle part of the first mask layer 20 is filled in the middle opening of the ' 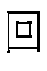 ' shaped structure and covers the seed layer 14, and the peripheral part of the first mask layer 20 covers the four edges of the ' 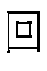 ' shaped structure. On the second face of the substrate structure layer 11, the middle part of the first mask layer 20 is filled in the middle opening of the ' 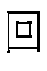 ' shaped structure and covers the conductive layer 15, and the peripheral part of the first mask layer 20 covers the four edges of the ' 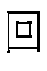 ' shaped structure, obtaining the structure as shown in FIG. 12c. The first mask layer 20 on the first face of the substrate structure layer 11 is printed and developed to form mask openings 22 thereon, obtaining the structure as shown in FIG. 12d. The mask openings 22 are formed on the first mask layer 20 covering the seed layer 14, and the mask openings 22 are not disposed on the overlapping part of the first mask layer 20 and the second mask layer 30, avoiding damaging the binding force between the first mask layer 20 and the second mask layer 30, and reducing the risk of deformation of the mask openings 22 caused by multi-layer materials. The metal grid lines 40 are formed in the mask openings 22 by electroplating, obtaining the structure as shown in FIG. 12e. The metal grid lines 40 are preferably copper grid lines and plated with metal tin layers thereon, and the metal tin layers cover the top of the copper grid lines. The first mask layer 20 and the second mask layer 30 are removed, obtaining the structure as shown in FIG. 12f. The seed layer 14 is etched and removed, exposing the metal grid lines 40, forming a solar cell, obtaining the structure as shown in FIG. 12g.

It should be noted that in the first specific example and the second specific example, the first mask layer 20 and the second mask layer 30 can be material layers with uniform thickness.

In a preferred embodiment, as shown in FIG. 13a, first, the first mask layer 20 is disposed on the first face and the second face of the solar cell substrate 10, the first mask layer 20 does not completely cover the first face of the solar cell substrate 10 and exposes the four edges of the first face of the solar cell substrate 10, and the first mask layer 20 does not completely cover the second face of the solar cell substrate 10 and exposes the four edges of the second face of the solar cell substrate 10, so as to avoid the first mask material from falling on the coating platform and polluting the coating platform when the first mask layer 20 is formed; then the second mask layer 30 covers the exposed four edges of the first face and second face of the solar cell substrate 10, the second mask layer 30 is partially disposed on the first mask layer 20, and the second mask layer 30 does not cover the mask pattern, so as to ensure that the second mask layer 30 and the first mask layer 20 overlap, avoid gaps at the joint of the second mask layer 30 and the first mask layer 20, and meanwhile avoid the second mask layer 30 from covering the mask pattern and affecting subsequent electroplating of the grid lines.

For example, as shown in FIG. 13b, adjacent to the same side of the solar cell substrate 10, a distance from one boundary of the first mask layer 20 to a first boundary of the solar cell substrate 10 is h1, a distance from one boundary of the mask pattern to the first boundary of the solar cell substrate 10 is h2, and a distance from one boundary of the second mask layer 30 to the first boundary of the solar cell substrate 10 is h3, and h1 is greater than 0 and h1 < h3 < h2. The first boundary of the solar cell substrate 10 is any boundary of the solar cell substrate 10, but is not a chamfered boundary.

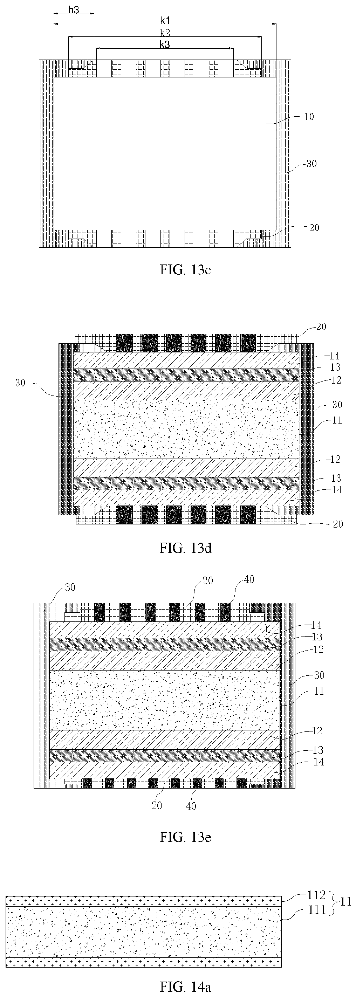

For example, as shown in FIG. 13c, the solar cell substrate 10 comprises a continuous first side, a second side and a third side, the first side and the third side are located on two sides of the second side, and the length of the second side of the substrate 10 of the solar cell is k1; the first mask layer 20 is symmetrically distributed along the perpendicular bisector of the second side of the substrate 10 of the solar cell, and the length of the first mask layer 20 along the extension direction of the second side of the substrate 10 of the solar cell is k2; the length of the mask pattern along the extension direction of the second side of the substrate 10 of the solar cell is k3, the mask pattern is symmetrically distributed on the first mask layer 20 along the perpendicular bisector of the second side of the substrate 10 of the solar cell; the distance from one side of the mask pattern adjacent to the first side to the first side is h31, the distance from the other side of the mask pattern adjacent to the third side to the third side is h32, and h31 and h32 are within the value range of h3; k1>k2 and 2h3+k2>k1 and 2h3+k3<k1 are satisfied. Preferably, the tolerance of k1 is ±p; when the length of the second side of the substrate 10 of the solar cell is k1-p, k1-k2-p>0 and (k1-p-k2)/2<h3<(k1-p-k3)/2 are satisfied; when the length of the second side of the substrate 10 of the solar cell is k1+p, k1-k2+p>0 and (k1+p-k2)/2<h3<(k1+p-k3)/2 are satisfied; in a more preferred embodiment, k1-k2-p>0 and (k1+p-k2)/2<h3<(k1-p-k3)/2 are satisfied, and h3 takes any value within the value range , which can ensure the setting of the first mask layer 20 and the second mask layer 30 for all the substrates 10 of the solar cell within the tolerance ±p.

It should be noted that the mask pattern is composed of the mask openings 22.

In a preferred embodiment, as shown in FIG. 13d, the second mask layer 30 is first arranged on the edge of the solar cell substrate 10, and then the first mask layer 20 is arranged, the first mask layer 20 does not completely cover the second mask layer 30 on the first face of the substrate 10 of the solar cell, the first mask layer 20 does not completely cover the second mask layer 30 on the second face of the substrate 10 of the solar cell, and ' 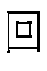 ' shaped steps are respectively formed on the four edges of the first face and the second face of the solar cell substrate 10, so as to avoid that the first mask material for forming the first mask layer 20 falls on the coating platform to contaminate the coating platform.

In a specific example, the metal grid lines 40 prepared by screen printing have a height of 15-20 µm and line width of about 45 µm. Due to the limitation of the screen, the line width of the metal grid lines 40 cannot be greatly reduced, and the aspect ratio cannot be improved. Preparing the metal grid lines 40 by electroplating, narrower mask openings 22 can be prepared by printing and developing, and then narrower metal grid lines 40 can be prepared by electroplating. The height of the metal grid lines 40 can reach 8-15 µm, and the line width is 10-20 µm. Therefore, the electroplating method can obtain narrower metal grid lines 40 and metal grid lines 40 with a larger aspect ratio, reduces the light shielding area of the metal grid lines 40, and improves the efficiency of the prepared solar cell.

In a preferred embodiment, as shown in FIG. 13e, when the first mask layer 20 is formed on the first face and the second face of the solar cell substrate 10, the first face of the solar cell substrate 10 is the light-receiving face, and the second face of the solar cell substrate 10 is the back light face, so that the thickness of the first mask layer 20 on the light-receiving surface is greater than the thickness of the first mask layer 20 on the back light surface. Therefore, the depth of the mask openings 22 on the light-receiving surface is greater than the depth of the mask openings 22 on the back light surface, and the height of the metal grid lines 40 on the light-receiving surface is greater than the height of the metal grid lines 40 on the back light surface, thereby improving the height-width ratio of the metal grid lines 40 on the light-receiving surface and improving the efficiency of the prepared solar cell. Meanwhile, the thickness of the first mask layer 20 on the back light surface is thinned, and the usage is reduced, thereby saving the cost. More preferably, the number of the metal grid lines 40 electroplated on the light-receiving surface is less than the number of the metal grid lines 40 electroplated on the back light surface, and the width of the metal grid lines 40 electroplated on the light-receiving surface is less than the width of the metal grid lines 40 electroplated on the back light surface, thereby reducing the light shielding area of the metal grid lines 40 on the light-receiving surface, further improving the height-width ratio of the metal grid lines 40 on the light-receiving surface, improving the efficiency of the prepared solar cell, and meanwhile, the number of the metal grid lines 40 on the back light surface is larger, the width of the metal grid lines 40 on the back light surface is larger, and the conductivity of the back light surface of the prepared solar cell is improved.

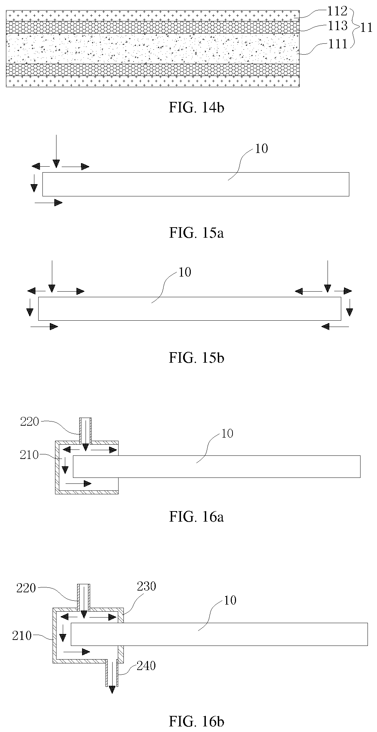

In a more specific embodiment, referring to FIG. 14a, the substrate structure layer 11 includes a crystalline silicon substrate layer 111 and intrinsic semiconductor layers 112 disposed on the crystalline silicon substrate layers 111 on the two faces thereof; in a preferred embodiment, referring to FIG. 14b, film tunneling layers 113 are further disposed between the crystalline silicon substrate layer 111 and the intrinsic semiconductor layers 112, and the film tunneling layer 113 includes any one of silicon oxide (SiO₂), silicon nitride (SiNₓ), silicon oxynitride (SiOₓN_{y}), aluminum oxide (Al₂O₃), and titanium oxide (TiO₂).

In other embodiments, the drying time of the pre-coated material is less than the drying time of the post-coated material; when the pre-coated material is the first mask material and the post-coated material is the second mask material, the drying time of the first mask material is less than the drying time of the second mask material; when the pre-coated material is the second mask material and the post-coated material is the first mask material, the drying time of the second mask material is less than the drying time of the first mask material. Since the pre-coated material will be dried again when the post-coated material is dried, in order to avoid the drying time of the pre-coated material being too long and causing excessive curing, it is needed that the drying time of the pre-coated material is less than the drying time of the post-coated material.

In preferred embodiments, the spraying point for coating the second mask material on the solar cell substrate 10 is arranged on the edge of the substrate 10. As shown in FIG. 15a, the solar cell substrate 10 is horizontally placed, and the spraying point for coating the second mask material is arranged on the left edge of the substrate 10. When the second mask material is sprayed, the second mask material spreads from the contact point to the surrounding, spreads to the right part which is the middle part of the solar cell substrate 10, and spreads to the left part which is the edge of the solar cell substrate 10. When the second mask material spreads to the edge of the solar cell substrate 10, the second mask material flows down along the left sidewall of the solar cell substrate 10 under the action of gravity. The second mask material has a surface tension, and the second mask material on the left sidewall pulls the second mask material on the left edge of the substrate 10 to move leftwards, and the second mask material on the left sidewall flows to the lower surface of the substrate 10 under the guidance of a coating guiding mechanism. The spraying point for coating the second mask material is single, and spraying one circle around the solar cell substrate 10 can complete the spraying of the second mask material on the solar cell substrate 10. As shown in FIG. 15b, the solar cell substrate 10 is horizontally placed, and the spraying point for coating the second mask material is two, which are arranged on the left edge and the right edge of the solar cell substrate 10 respectively, and the two spraying points simultaneously coat the left edge and the right edge of the solar cell substrate 10. After the coating of the left edge and the right edge of the substrate 10 is completed, the solar cell substrate 10 is rotated by 90 degrees or the two spraying points are moved to the front and rear edges of the solar cell substrate 10, and then the front edge and the rear edge of the solar cell substrate 10 are simultaneously coated. In other embodiments, the spraying points can be four, which simultaneously or sequentially coat the four edges of the solar cell substrate 10.

Further, referring to FIG. 16a, the coating guiding mechanism comprises a "U"-shaped groove 210 and a feeding pipe 220 arranged on one sidewall of the "U"-shaped groove 210 and communicating with the "U"-shaped groove 210; during coating, the edge of the solar cell substrate 10 is inserted into the "U"-shaped groove 210 to form a "U"-shaped filling area in the "U"-shaped groove 210, the feeding pipe 220 is located above the solar cell substrate 10, the second mask material flows from the feeding pipe 220 into the "U"-shaped filling area, the "U" filling area is filled with the second mask material to complete coating of an area on the edge of the solar cell substrate 10, then the coating guiding mechanism moves relative to the solar cell substrate 10 along the edge of the solar cell substrate 10 to complete coating of subsequent continuous areas. No blocking member is arranged at the outlet of the "U"-shaped groove 210, and the width (length in the left-right direction in the figure) of the second mask material covered on the upper face of the solar cell substrate 10 is greater than the width of the second mask material covered on the lower face of the solar cell substrate 10.

As shown in FIG. 16b, a blocking member 230 is arranged at the outlet of the "U"-shaped groove 210 to limit the flow position of the second mask material on the upper and lower faces of the solar cell substrate 10, so that the width of the second mask material covered on the upper face of the solar cell substrate 10 is equal to the width of the second mask material covered on the lower face of the solar cell substrate 10, and a discharging pipe 240 is arranged on the other sidewall of the "U"-shaped groove 210 and located below the solar cell substrate 10. In this embodiment, the second mask material can be fed from the discharging pipe 240 and discharged from the feeding pipe 220.

### Embodiment 2

A preparation method for a solar cell, including the following steps:
S21, forming a first mask layer 20 with mask openings 22 on the first face and/or the second face of the solar cell substrate 10.

Different from Embodiment 1, the mask openings 22 in this embodiment is formed at the same time as the first mask layer 20, for example, the first mask material is coated on local areas of the seed layer 14, the areas of the seed layer 14 without the first mask material is exposed, and the areas of the seed layer 14 without the first mask material constitutes the mask openings 22.

Specifically, the step S21 comprises the following steps:
S211, arranging a mask screen on the seed layer 14;
S212, coating the first mask material in the meshes of the mask screen;
S213, leveling the first mask material coated in the meshes of the mask screen;
S214, drying and curing the first mask material leveled in the meshes of the mask screen;
S215, removing the mask screen to form the first mask layer 20 with the mask openings 22 on the seed layer 14.

The mask screen can be used to accurately control the forming of the first mask layer 20 with the mask openings 22, especially in the case of low viscosity of the first mask material, the shape of the mask openings 22 can be well controlled, and the mask openings 22 are prevented from being deformed in the forming process. In other embodiments, the mask screen can be removed first, and then the first mask material is dried and cured to form the first mask layer 20 with the mask openings 22; or the mask screen is removed in the drying process.

S13, forming a second mask layer 30 on the edge of the solar cell substrate 10, wherein the edge of the solar cell substrate 10 at least includes all the sidewalls of the solar cell substrate 10.

S14, electroplating to form metal grid lines 40 in the mask openings 22.

S 15, removing the first mask layer 20 and the second mask layer 30.

Preferably, when the solar cell substrate 10 is provided with a seed layer 14, step S15 includes: first, removing the first mask layer 20 and the second mask layer 30, and then etching and removing the seed layer 14 on the solar cell substrate 10.

The embodiment is an improvement based on the embodiment 1, and the same technical details as those in embodiment 1 are omitted in this embodiment. It should be understood that the technical solutions and technical details in embodiment 1 can also be applied to this embodiment without departing from the principle of the embodiment.

### Embodiment 3

The conductivity of the TCO layer 13 is enhanced, but the light transmittance is reduced when the thickness of the TCO layer 13 is increased; the conductivity of the TCO layer 13 is weakened, but the light transmittance is improved when the thickness of the TCO layer 13 is reduced; and the existing technology cannot solve this technical contradiction.

To this end, the embodiment provides a preparation method for a solar cell, which includes the following steps:
S31, preparing a TCO layer 13 on the substrate structure layer 11, and a thickness of at least one TCO layer 13 being M to form a TCO thinning layer, wherein the TCO layer 13 on the substrate structure layer 11 can be one or two, when the TCO layer 13 on the substrate structure layer 11 is one, the thickness of the one TCO layer 13 can be M to form one TCO thinning layer; when the TCO layer 13 on the substrate structure layer 11 is two, the thickness of one of the two TCO layers 13 can be M to form one TCO thinning layer, or the thickness of both of the two TCO layers 13 can be M to form two TCO thinning layers.

S32, electroplating metal grid lines 40 on the TCO thinning layer, according to the thickness of one TCO thinning layer, controlling the width of the metal grid lines 40 on the one TCO thinning layer to be N, and the spacing between adjacent metal grid lines 40 on the one TCO thinning layer to be T;

The value range of M is 40 nm-80 nm, the value range of N is 20-40 µm, and the value range of T is 0.3-1.4 mm.

Preferably, M can be 40 nm, 45 nm, 50 nm, 55 nm, 60 nm, 65 nm, 70 nm or 75 nm; N can be 20 µm, 22 µm, 24 µm, 26 µm, 28 µm, 30 µm, 32 µm, 34 µm, 36 µm, 38 µm or 40 µm, and T can be 0.3 mm, 0.4 mm, 0.5 mm, 0.6 mm, 0.7 mm, 0.8 mm, 0.9 mm, 1.0 mm, 1.1 mm, 1.2 mm, 1.3 mm or 1.4 mm.

Preferably, in step S31, the doped semiconductor layer 12 and the TCO layer 13 are sequentially arranged on the first face and the second face of the substrate structure layer 11 in a direction away from the substrate structure layer 11, so that the thickness of the TCO layer 13 on the first face of the substrate structure layer 11 is M to form a first TCO thinning layer, and/or the thickness of the TCO layer 13 on the second face of the substrate structure layer 11 is M to form a second TCO thinning layer.

When the prepared is a bifacial electrode solar cell, in step 31, the thickness of both the TCO layers 13 on the first face and the second face of the substrate structure layer 11 is M, respectively forming a first TCO thinning layer and a second TCO thinning layer; in step 32, the metal grid lines 40 are electroplated on the first TCO thinning layer and the second TCO thinning layer, according to the thickness of the first TCO thinning layer, the width of the metal grid lines 40 on the first TCO thinning layer is controlled to be N, and the spacing between adjacent metal grid lines 40 on the first TCO thinning layer is T, and/or, according to the thickness of the second TCO thinning layer, the width of the metal grid lines 40 on the second TCO thinning layer is controlled to be N, and the spacing between adjacent metal grid lines 40 on the second TCO thinning layer is T.

When the prepared is a monofacial electrode solar cell, in step 31, the thickness of the TCO layer 13 on the first face or the second face of the substrate structure layer 11 is M to form a TCO thinning layer on the corresponding face; in step 32, the metal grid lines 40 are electroplated on the one TCO thinning layer, according to the thickness of the one TCO thinning layer, the width of the metal grid lines 40 on the one TCO thinning layer is controlled to be N, and the spacing between adjacent metal grid lines 40 on the one TCO thinning layer is T.

The thickness of the TCO layer 13 is reduced to form a TCO thinning layer, which causes the conductivity of the TCO layer 13 to be weakened and the light transmittance to be improved; the spacing between adjacent metal grid lines 40 is reduced, which compensates for the conductivity of the TCO layer 13, so that the prepared solar cell does not reduce the efficiency due to the weakened conductivity of the TCO layer 13, however, the number of metal grid lines 40 on the same TCO thinning layer is increased, which increases the total shading area of all metal grid lines 40 on the same TCO thinning layer, and further reduces the efficiency of the prepared solar cell; the electroplating method can prepare narrower metal grid lines 40, even if the number of metal grid lines 40 on the same TCO thinning layer is increased, the total shading area of all metal grid lines 40 on the same TCO thinning layer is not increased, and can even be reduced, so that the efficiency of the prepared solar cell is finally improved, and the usage of TCO material is also saved, and the cost of preparing the solar cell is saved.

Preferably, the method for forming the metal grid lines 40 in step S32 can adopt the technical solutions in Embodiments 1 and 2, so as to improve the efficiency of the prepared solar cell.

Preferably, in order to improve the electroplating quality of the metal grid lines 40, a seed layer 14 is firstly arranged on the TCO layer 13 on the first face and/or the second face of the substrate structure layer 11, the metal grid lines 40 are electroplated on the seed layer 14, and then the seed layer 14 is etched and removed.

The anti-reflection layer or the TCO layer 13 on the solar cell substrate 10 is usually formed by a physical vapor deposition or a chemical vapor deposition method. For a heterojunction cell, transparent conductive oxide needs to be deposited on both the light-receiving surface and the back surface to form the TCO layers 13. Usually, the solar cell substrate 10 is placed on a tray with openings, and the tray passes through a target position section for depositing the light-receiving surface layer and a target position section for depositing the back surface layer. The positions of the solar cell substrate 10 in contact with the tray are shielded, so that the transparent conductive oxide cannot be deposited on the shielded positions to form the TCO layer 13, thereby exposing the doped semiconductor layer 12 (for example, an amorphous silicon or microcrystalline silicon layer) located on the shielded positions of the solar cell substrate 10. The surface of the doped semiconductor layer 12 is directly in contact with metal particles in the external environment, which reduces the efficiency of the prepared solar cell. For example, in the process of electroplating copper, the surface of the doped semiconductor layer 12 is directly in contact with the seed layer 14, which has two risks: (1) the heating treatment (for example, drying) process causes the seed layer 14 to diffuse into the solar cell substrate 10 through the doped semiconductor layer 12, resulting in loss of electrical performance of the solar cell; and (2) the solution for removing the seed layer 14 contains copper ions, which are easy to adhere to the doped semiconductor layer 12 during cleaning and to diffuse into the solar cell substrate 10 during subsequent heating treatment and outdoor use of the solar cell, also resulting in loss of electrical performance of the solar cell. In the above process of electroplating copper, the metal particles include metal elements on the seed layer 14, such as copper elements, and copper ions.

Therefore, the solar cell preparation method in the embodiment further comprises a step 33 between the step 31 and the step 32, that is, an isolation layer 132 is arranged on the surface of the doped semiconductor layer 12. Preferably, the isolation layer 132 is arranged on the surface of the doped semiconductor layer 12 by vapor deposition.

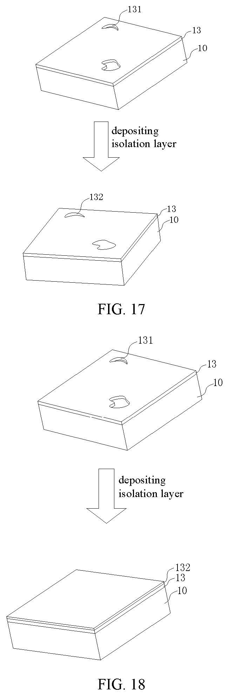

For example, as shown in FIG. 17 and FIG. 18, the solar cell substrate 10 comprises the TCO layer 13, and the TCO layer 13 has defect pits 131 exposing the doped semiconductor layer 12, and the isolation layer 132 is used to cover the defect pits 131. In the solution shown in FIG. 17, the isolation layer 132 only covers the defect pits 131 on the TCO layer 13, and does not increase the thickness of the solar cell substrate 10; in the solution shown in FIG. 18, the isolation layer 132 forms a new layer on the TCO layer 13 and covers the defect pits 131, and the position of the defect pits 131 does not need to be identified in advance, and the defect pits 131 can be quickly covered.

The embodiment can avoid the problem that metal particles diffuse into the solar cell substrate 10 through the doped semiconductor layer 12, causing the loss of the electrical performance of the solar cell, and can improve the efficiency of the prepared solar cell. It should be noted that the anti-reflection layer or the TCO layer 13 basically covers the doped semiconductor layer 12 of the solar cell substrate 10, but due to the defects of the manufacturing process, the anti-reflection layer or the TCO layer 13 cannot completely cover the doped semiconductor layer 12 of the solar cell substrate 10, so that there is a locally exposed doped semiconductor layer 12. In order to complementally cover the locally exposed doped semiconductor layer 12, the isolation layer 132 is arranged (preferably deposited) on the locally exposed doped semiconductor layer 12, and the material of the isolation layer 132 can be the same as that of the anti-reflection layer or the TCO layer 13. The material of the anti-reflection layer can be silicon oxide, silicon nitride, aluminum oxide, or the like.

Preferably, the step 31 and the step 32 further comprise a step S34 of cleaning to remove the metal particles attached to the doped semiconductor layer 12. Specifically, the cleaning solution is a mixed solution of acid, complexing agent, and oxidant, and a non-reuse spraying mode or a soaking type large-flow circulation is used. By cleaning to remove the metal particles attached to the doped semiconductor layer 12, the problem that the metal particles diffuse into the prepared solar cell during subsequent heating treatment and outdoor use of the solar cell, causing the loss of the electrical performance of the prepared solar cell, can be avoided.

Preferably, the step 32 further comprises a step S35 of forming an anti-reflection layer on the TCO layer 13. The anti-reflection layer can increase the light transmittance of the prepared solar cell, and further improve the efficiency of the prepared solar cell.

In a specific embodiment, the preparation method for a solar cell includes the following steps:
S31, sequentially preparing doped semiconductor layers 12 and TCO layers 13 on the first face and the second face of the substrate structure layer 11 in a direction away from the substrate structure layer 11, so that the thickness of the TCO layer 13 on the first face of the substrate structure layer 11 is M to form a first TCO thinning layer, and/or the thickness of the TCO layer 13 on the second face of the substrate structure layer 11 is M to form a second TCO thinning layer;
S34, cleaning to remove metal particles attached to the doped semiconductor layer 12;
S33, preparing isolation layers 132 on the surfaces of the doped semiconductor layers 12;

S32, according to the thickness of the first TCO thinning layer, controlling the width of the metal grid lines 40 on the first TCO thinning layer to be N, and the spacing between adjacent metal grid lines 40 on the first TCO thinning layer to be T, and/or according to the thickness of the second TCO thinning layer, controlling the width of the metal grid lines 40 on the second TCO thinning layer to be N, and the spacing between adjacent metal grid lines 40 on the second TCO thinning layer to be T.

The process of electroplating the metal grid line 40 in step S32 includes:
S11, forming a first mask layer 20 on the first face and/or the second face of the solar cell substrate 10;
S12, forming mask openings 22 on the first mask layer 20;
S13, forming a second mask layer 30 on the edge of the solar cell substrate 10, wherein the edge of the solar cell substrate 10 at least includes all the sidewalls of the solar cell substrate 10;
S14, electroplating to form metal grid lines 40 in the mask openings 22;
S15, removing the first mask layer 20 and the second mask layer 30;
S35, forming an anti-reflection layer on the TCO layer 13.

Preferably, the isolation layer 132 can be a cover layer on the TCO thinning layer, and the sum of the thicknesses of the isolation layer 132 and the TCO thinning layer is M.

Preferably, the mask openings 22 are obtained by printing and developing. The fine mask openings 22 with a width of N are formed by printing and developing, and the metal grid lines 40 with a width of N are formed in the mask openings 22 by electroplating, so that the spacing between adjacent metal grid lines 40 on the same TCO layer 13 can be reduced, that is, the number of metal grid lines 40 on the same TCO layer 13 is increased, and the light shielding area of all the metal grid lines 40 on the same TCO layer 13 is not enlarged; because the spacing between adjacent metal grid lines 40 is reduced, the conductivity of all the metal grid lines 40 on the same TCO layer 13 is improved, so that the thickness of the TCO layer 13 can be reduced. Therefore, when the solar cell is prepared, the thickness of the TCO layer 13 is set to M to form a TCO thinning layer, and the metal grid lines 40 are formed on the TCO thinning layer by electroplating according to the thickness of the TCO thinning layer, the width of the metal grid lines 40 on the TCO thinning layer is controlled to be N, and the spacing between adjacent metal grid lines 40 on the TCO thinning layer is T. Thus, the thickness of the TCO layer 13 can be reduced, the preparation cost of the solar cell is saved, and the efficiency of the prepared solar cell is maintained or improved.

In another specific embodiment, the steps S11 and S12 can be replaced by a step S31 of forming a first mask layer with mask openings on the first face and/or the second face of the solar cell substrate.

The embodiment of the invention also provides a solar cell prepared by the methods in the embodiments 1-3, so the solar cell has the characteristics and advantages of the method in the embodiments 1-3.

It should be noted that in the embodiments 1-3, the first face of the solar cell substrate 10 refers to a surface of the solar cell substrate 10 or a surface of a material layer directly or indirectly contacting the surface of the solar cell substrate 10, for example, the first mask layer 20 is arranged on a surface of the solar cell substrate 10, which can be expressed as the first mask layer 20 is arranged on the first face of the solar cell substrate 10, when a surface of the solar cell substrate 10 is an outer surface of the seed layer 14, and an inner surface of the seed layer 14 is connected to the TCO layer 13 on the solar cell substrate 10, if the second mask layer 30 is further arranged on the outer side surface of the first mask layer 20, it can also be expressed as the second mask layer 30 is arranged on the first face of the solar cell substrate 10, and the second mask layer 30 is indirectly arranged on the outer surface of the seed layer 14. The first face of the solar cell substrate 10 can be a surface of the solar cell substrate 10, an outer surface of the first mask layer 20 or an outer surface of the second mask layer 30, and the specific meaning should be understood according to the context. Here, the orientation close to the inside of the solar cell substrate 10 is inner oriention, and the orientation away from the inside of the solar cell substrate 10 is outer orientation. Similarly, the second face of the solar cell substrate 10 should also be understood in the same way.

In Embodiments 1-3, the first face of the substrate structure layer 11 refers to one surface of the substrate structure layer 11 or one surface of a material layer in direct or indirect contact with the surface of the substrate structure layer 11, for example, one surface of the substrate structure layer 11 is sequentially provided with the doped semiconductor layer 12 and the TCO layer 13 in the direction away from the substrate structure layer 11, where the doped semiconductor layer 12 is directly provided on one surface of the substrate structure layer 11, and the TCO layer 13 is indirectly provided on one surface of the substrate structure layer 11, the first face of the substrate structure layer 11 can be one surface of the substrate structure layer 11, an outer surface of the doped semiconductor layer 12, or an outer surface of the TCO layer 13. In particular, the first face of the substrate structure layer 11 can be the same surface as the first face of the solar cell substrate 10. Similarly, the second face of the substrate structure layer 11 should be understood in the same way.

The above embodiments are only for illustrating the technical concept and characteristics of the invention, and the purpose is to enable those skilled in the art to understand the content of the invention and implement it, and cannot limit the protection scope of the invention. Any equivalent changes or modifications made according to the essence of the invention shall be covered within the protection scope of the invention.

## Claims

1. A preparing method for a solar cell, is **characterized in that**, the preparing method comprises the following steps:
S11, forming a first mask layer on a first face and/or a second face of a solar cell substrate;
S12, forming mask openings on the first mask layer;
S13, forming a second mask layer on an edge of the solar cell substrate, the edge of the solar cell substrate at least comprising all sidewalls of the solar cell substrate;
S14, electroplating to form metal grid lines in the mask openings;
S15, removing the first mask layer and the second mask layer.

2. The preparing method for a solar cell of claim 1, is **characterized in that**, the first mask layer is made of a photosensitive resin, and the second mask layer is made of a thermosetting resin.

3. The preparing method for a solar cell of claim 1, is **characterized in that**, surfaces of the solar cell substrate are divided into three areas A, B and C; the first face of the solar cell substrate is composed of the A area and the B area, wherein the B area is adjacent to an edge of the first face; on the first face, the B area is annular and surrounds the A area; and the C area is all sidewalls of the solar cell substrate;
the first mask layer covers all the A area on the first face and at least part of the B area on the first face; the second mask layer covers all the C area and at least part of the B area on the first face; and a part of the first mask layer and a part of the second mask layer overlap in the B area on the first face.

4. The preparing method for a solar cell of claim 3, is **characterized in that**, the second face of the solar cell substrate is composed of the A area and the B area, wherein the B area is adjacent to an edge of the second face; on the second face, the B area is annular and surrounds the A area; the first mask layer covers all the A area on the second face and at least part of the B area on the second face; the second mask layer covers at least part of the B area on the second face; and a part of the first mask layer and a part of the second mask layer overlap in the B area on the second face.

5. The preparing method for a solar cell of claim 4, is **characterized in that**, the second mask layer is in a shape of "C" in a cross section along an up-down direction.

6. The preparing method for a solar cell of claim 3, is **characterized in that**, the overlapping parts of the first mask layer and the second mask layer in the B area are annular.

7. The preparing method for a solar cell of claim 3, is **characterized in that**, the edge of the first mask layer comprises a first inclined thinning layer, the edge of the second mask layer comprises a second inclined thinning layer, and the first inclined thinning layer and the second inclined thinning layer overlap to form the overlapping parts of the first mask layer and the second mask layer in the B area.

8. The preparing method for a solar cell of claim 1, is **characterized in that**, coated second mask material covers the edge of the first face to form a first edge strip, a second edge strip, a third edge strip and a fourth edge strip in sequence, and widths of the first edge strip, the second edge strip, the third edge strip and the fourth edge strip are d3, d4, d5 and d6 in sequence, wherein d3, d4, d5 and d6 are in range of 0.2 - 5 mm.

9. The preparing method for a solar cell of claim 8, is **characterized in that**, a side length of the solar cell substrate is d0, and ratios of d3, d4, d5 and d6 to d0 are in a range of 0.1 % - 3 %.

10. The preparing method for a solar cell of claim 1, is **characterized in that**, left and right edges of the first face of the solar cell substrate are coated to form a first edge strip and a third edge strip firstly, and then upper and lower edges of the first face of the solar cell substrate are coated to form a second edge strip and a fourth edge strip; the first edge strip intersects with the second edge strip, the first edge strip intersects with the fourth edge strip, the third edge strip intersects with the second edge strip, and the third edge strip intersects with the fourth edge strip.

11. The preparing method for a solar cell of claim 1, is **characterized in that**, second mask material is coated on an edge of the first face of the solar cell substrate in a counterclockwise or clockwise direction to form an annular area from end-to-end.

12. The preparing method for a solar cell of claim 1, is **characterized in that**, the step S15 comprises: dissolving and removing the second mask layer firstly, and then swelling the first mask layer to separate the first mask layer from the solar cell substrate.

13. The preparing method for a solar cell of claim 1, is **characterized in that**, when the metal grid lines are an easily-oxidized metal, an anti-oxidation layer is arranged on surface of the metal grid lines.

14. The preparing method for a solar cell of claim 13, is **characterized in that**, the anti-oxidation layer covers a top and a sidewall of the metal grid lines.

15. The preparing method for a solar cell of claim 14, is **characterized in that**, the anti-oxidation layer is obtained through a chemical displacement reaction.

16. The preparing method for a solar cell of claim 1, is **characterized in that**, the step S13 is performed after the step S11 and before the step S14, or the step S13 is performed before the step S11.

17. The preparing method for a solar cell of claim 1, is **characterized in that**, a first mask layer is formed on the first face and the second face of the solar cell substrate firstly, the first mask layer does not completely cover the first face of the solar cell substrate and exposes four edges of the first face of the solar cell substrate, the first mask layer does not completely cover the second face of the solar cell substrate and exposes four edges of the second face of the solar cell substrate; and a second mask layer is then formed on the four edges of the first face and the second face of the solar cell substrate exposed, the second mask layer is formed on the first mask layer and does not cover a mask pattern.

18. The preparing method for a solar cell of claim 17, is **characterized in that**, on a same side of the solar cell substrate, a distance from one boundary of the first mask layer to a first boundary of the solar cell substrate is h1, a distance from one side of the mask pattern to the first boundary of the solar cell substrate is h2, and a distance from one side of the second mask layer to the first boundary of the solar cell substrate is h3; and h1 is greater than 0 and h1 < h3 < h2.

19. The preparing method for a solar cell of claim 18, is **characterized in that**, the solar cell substrate comprises a first side, a second side and a third side in sequence, the first side and the third side are located on two sides of the second side, and a length of the second side of the solar cell substrate is k1; the first mask layer is symmetrically distributed along a perpendicular bisector of the second side of the solar cell substrate, and a length of the first mask layer along an extension direction of the second side of the solar cell substrate is k2; a length of the mask pattern along the extension direction of the second side of the solar cell substrate is k3, and the mask pattern is symmetrically distributed on the first mask layer along the perpendicular bisector of the second side of the solar cell substrate; a distance from one boundary of the mask pattern on one side of the first side to the first side is h31, and a distance from the other boundary of the mask pattern on one side of the third side to the third side is h32, h31 and h32 are within a range of h3; and k1 > k2, 2h3 + k2 > k1 and 2h3 + k3 < k1 are satisfied.

20. The preparing method for a solar cell of claim 19, is **characterized in that**, a tolerance of k1 is ±p; and k1 - k2 - p > 0 and (k1 + p - k2)/2 < h3 < (k1 - p - k3)/2 are satisfied.

21. The preparing method for a solar cell of claim 1, is **characterized in that**, the metal grid lines are grid lines with width gradients.

22. The preparing method for a solar cell of claim 1, is **characterized in that**, a width of the second mask material covered on an upper surface of the solar cell substrate is greater than a width of the second mask material covered on a lower surface of the solar cell substrate.

23. The preparing method for a solar cell of any one of claims 1 to 22, is **characterized in that**, when the first mask layer is formed on the first face and the second face of the solar cell substrate, the first face of the solar cell substrate is a light-receiving surface, and the second face of the solar cell substrate is a back light surface, so that a thickness of the first mask layer on the light-receiving surface is greater than a thickness of the first mask layer on the back light surface.

24. The preparing method for a solar cell of any one of claims 1 to 22, is **characterized in that**, a number of the metal grid lines on the light-receiving surface is less than a number of the metal grid lines on the back light surface.

25. The preparing method for a solar cell of any one of claims 1 to 22, is **characterized in that**, the preparing method further comprises the following steps:
S31, preparing a TCO layer on a substrate structure layer, and a thickness of at least one TCO layer being M to form a TCO thinning layer;
S32, electroplating metal grid lines on the TCO thinning layer, controlling widths of the metal grid lines on the one TCO thinning layer to be N according to the thickness of the one TCO thinning layer,, and a distance between adjacent metal grid lines on the one TCO thinning layer to be T;
wherein M is in a range of 40 nm to 80 nm, N is in a range of 20 µm to 40 µm, and T is in a range of 0.3 mm to 1.4 mm.

26. The preparing method for a solar cell of claim 25, is **characterized in that**, in the step S31, doped semiconductor layers and TCO layers are sequentially disposed on the first face and the second face of the substrate structure layer along a direction away from the substrate structure layer, so that a thickness of the TCO layer on the first face of the substrate structure layer is M to form a first TCO thinning layer, and/or a thickness of the TCO layer on the second face of the substrate structure layer is M to form a second TCO thinning layer.

27. The preparing method for a solar cell of claim 25, is **characterized in that**, between the step 31 and the step 32, the method further comprises a step 33 of disposing an isolation layer on a surface of the doped semiconductor layer.

28. The preparing method for a solar cell of claim 25, is **characterized in that**, between the step 31 and the step 32, the method further comprises a step S34 of cleaning to remove metal particles attached to the doped semiconductor layer.

29. The preparing method for a solar cell of claim 1, is **characterized in that**, the steps S11 and S12 are replaced by a step S21 of forming a first mask layer with mask openings on the first face and/or the second face of the solar cell substrate.

30. A solar cell, is **characterized in that**, the solar cell is prepared by the preparing method for a solar cell of any one of claims 1 to 29.
